# EUROPEAN PATENT APPLICATION

(11) **EP 2 061 019 A1**
(43) Date of publication of application: **20.05.2009**
(21) Application number: 07806389.8
(22) Date of filing: 30.08.2007
(51) Int. Cl.: G09F 9/00, B32B 7/02, H05K 9/00

(54) **DISPLAY FILTER AND ITS MANUFACTURING METHOD, AND DISPLAY MANUFACTURING METHOD**

(30) Priority: 06.09.2006 JP 2006241224; 22.11.2006 JP 2006315156
(71) Applicant: Toray Industries, Inc., Tokyo, 103-8666 (JP)
(72) Inventor: KIRIMOTO, Takayoshi, Otsu-shi, Shiga 520-8558 (JP); MIKAMI, Yuko, Otsu-shi, Shiga 520-8558 (JP); MATSUMOTO, Toru, Otsu-shi, Shiga 520-8558 (JP)
(74) Representative: Webster, Jeremy Mark
(86) International application number: PCT/JP2007/066912
(87) International publication number: WO 2008/029709

(57) **Abstract**

It is an object to provide a filter for display comprising only one piece of plastic film as a substrate for price-reduction, using a laminated body having a conductive layer and a functional layer on the substrate and having an electrode capable of electric conduction to a display housing in the peripheral part of the laminate body, and a production method thereof. Provided is a filter for display, which is a laminated body including

a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function, which has a cavity reaching at least conductive layer, while penetrating through the functional layer from the surface of the functional layer side, in at least one part of the peripheral part of the laminated body.

## Description

### TECHNICAL FIELD

The present invention relates to a filter for display, its production method and a production method of display.

### BACKGROUND ART

Displays such as liquid crystal display (hereinafter LCD) and plasma display (hereinafter PDP) are display units capable of clear color display. For display, ordinarily, a front filter (hereinafter, simply referred to as filter for display) aiming at preventing reflection of outside light, shielding electromagnetic waves generated from display and protecting display is disposed at the viewing side of display. In particular, since PDP generates strong electromagnetic waves in principle of the structure and operation, there is a fear affecting human body and other instrument, and a filter for display provided with electromagnetic wave shielding function and antireflection function is usually used.

An ordinary filter for display is formed by laminating an optically functional film having antireflection function, color tone adjusting function, near-infrared ray shielding function and the like, and a plastic film (electromagnetic wave shielding film) provided with a conductive layer (electromagnetic wave shielding layer) via an adhesive layer.

In recent years, filters for display have been forced to cut costs in accompanying with price-reduction of display. In contrast with a filter for display composed of two pieces of films (hereinafter called two-piece film filter) as described above, price-reduction becomes possible by using only one piece of plastic film. As such filter for display composed of one piece of plastic film (hereinafter called one-piece film filter), for example, there are proposed a filter having an antireflection layer on one surface of plastic film as well as a conductive layer (electromagnetic wave shielding layer) and a near-infrared ray shielding layer on the other surface (Patent document 1), and a filter for display that a conductive layer is provided on a plastic film and further an antireflection layer is laminated thereon (Patent documents 2 to 4). However, the conductive layer in Patent documents 2 to 4 does not intend a conductive mesh, so the present invention differs from that in constitution. Conventionally, it has not been known that a functional layer such as hard coating layer and antireflection layer is formed by coating/forming on a conductive layer.

On the other hand, when a filter for display is mounted in a display, an electrode for electrically connecting a conductive layer of a filter for display to a display housing (external electrode) is provided.

As a method for forming an electrode on a conductive layer, a method that the peripheral edge part of conductive layer is peeled away has conventionally been carried out. In this method, the peeled part of peripheral edge part of conductive layer serves as an electrode. Regarding formation of this peeled part of conductive layer (hereinafter called a peeled electrode), it is performed, in the case of the foregoing two-piece film filter, by laminating an optically functional film of smaller size than an electromagnetic shielding film having a conductive layer, and it is performed, in the case of one-piece film filter of the former type (filter having an antireflection layer on one surface of plastic film as well as a conductive layer (electromagnetic wave shielding layer) and near-infrared ray shielding adhesive layer on the other surface), by providing a part that a near-infrared ray shielding adhesive layer is not covered in the peripheral edge part, in the case of one-piece film filter of the latter type (a filter for display that a conductive layer is provided on a plastic film and further an antireflection layer is laminated thereon), by coating an antireflection layer so that an edge part of conductive layer is exposed. To ensure a sufficient electromagnetic wave shielding performance, it is preferable to provide electrodes in four sides of a rectangular filter for display, but for providing the foregoing peeled electrodes in the four sides, in the case of two-piece film filter, it is necessary to laminate an electromagnetic wave shielding film and a functional film each other as sheet (sheet-to-sheet lamination method). However, this sheet-to-sheet lamination method has a drawback being inferior in productivity.

Regarding one-piece film filter of the former type (filter having an antireflection layer on one surface of plastic film as well as a conductive layer (electromagnetic wave shielding layer) and near-infrared ray shielding adhesive layer on the other surface), in the case of providing peeled electrodes in four sides of filter, being similar to above, it is necessary to laminate an electromagnetic wave shielding film having a conductive layer and a sheet having a near-infrared ray shielding adhesive layer by sheet-to-sheet lamination method, and there is a problem similar to above being inferior in productivity.

To increase productivity of filters for display, a roll-to-roll lamination method is effective. Namely, it is a method for producing a laminated body of long roll, wherein an electromagnetic wave shielding film and a functional film or, an electromagnetic wave shielding film and near-infrared ray shielding adhesive layer are laminated by roll-to-roll in a continuous production line.

In the case of roll-to-roll lamination method, by bonding a functional film or near-infrared ray shielding adhesive layer of narrower width than an electromagnetic wave shielding film, a peeled electrode parallel to a roll-winding direction (stream direction) can be provided in both edge parts in the width direction of roll. However, electrodes perpendicular to the stream direction of roll need to form electrodes after being subjected to cut process into a sheet form.

On the other hand, in the case of one-piece film filter of the latter type (a filter for display that a conductive layer is provided on a plastic film and further an antireflection layer is laminated thereon), an antireflection layer is laminated on a conductive layer by coating or the like, in a common coating production line, it is impossible to form peeled electrodes on four sides. Namely, a continuous coating is conducted by roll-to-roll method in a common coating production line, by adjusting the coat width of antireflection layer and providing non-coat part in both edge parts in the width direction of conductive layer, peeled electrode can be formed on two sides, but peeled electrode cannot be formed in the direction perpendicular to the stream direction of coating. Therefore, by being subjected to a cut process into a sheet form after completion of coating of antireflection layer, electrodes need to be formed on the residual two sides (direction perpendicular to the stream direction of coating) that peeled electrode are not formed.

There is a known method that electrodes are formed after a roll filter produced in a continuous production line is subjected to a cut process into a sheet-like filter of the final specification size. For example, there are proposed a method that peeled electrodes are formed on the edge part by providing a cut line by irradiation with a laser or the like, and peeling away a transparent film and adhesive layer along the cut line (Patent document 5), a method that a conductive layer is exposed by providing two cut lines at intervals of 5 to 20 mm by irradiation with a laser or the like, and peeling a transparent film and adhesive layer in a striped shape, and a method that a conductive coating material is thinly coated on an exposed part to prevent a remaining adhesion due to remaining of a sticking material in the exposed part (Patent document 6).

The electrode forming methods described in the above Patent documents 5 and 6 are targeting a filter for display that an electromagnetic wave shielding film and an optically functional film (transparent film) as described above are laminated via adhesive layer. The technique is that a cut line is made by irradiation with a laser or the like, and along this cut line, the boundary of conductive layer and adhesive layer are detached physically. In other words, the presence of adhesive layer enables the physical detachment.

However, in the electrode forming methods described in Patent documents 5 and 6, the presence of adhesive layer enables physical detachment, but there is a problem that the adhesive layer is not completely detached and removed, thus electric conduction to an outside electrode becomes insufficient. In the electrode forming methods described in Patent documents 5 and 6, there are also problems that (1) a step for detaching/removing a functional film and the like laminated on a conductive layer is required, (2) conductive mesh in a conductive layer is broken in detaching/removing an optically functional film and the like, and (3) lamination strength (adhesion strength) between conductive layer and functional layer becomes insufficient because a detachable sticking material is used to increase detachability of an optically functional film and the like.

To realize price-reduction of filter, the filter of the present invention is composed of only one piece of plastic film, and further it is preferable to reduce the numbers of adhesive layers. Therefore, it is a preferable embodiment that no adhesive layer lies between conductive layer and plastic film, or between conductive layer and functional layer. For such filter for display having a plastic film or functional layer without laying an adhesive layer on the conductive layer, the electrode forming method conducting physical detachment by utilizing an adhesive layer as in Patent documents 5 and 6 cannot be applied.
Patent document 1: Japanese Unexamined Patent Publication No. 2006-153950
Patent document 2: Japanese Unexamined Patent Publication No. 2000-214321
Patent document 3: Japanese Unexamined Patent Publication No. 2001-253008
Patent document 4: Japanese Unexamined Patent Publication No. 2006-54377
Patent document 5: Japanese Unexamined Patent Publication No. 2002-43791
Patent document 6: Japanese Unexamined Patent Publication No. 2004-327720

### DISCLOSURE OF THE INVENTION

### Problems to be Solved by the Invention

Therefore, an object of the present invention is to provide a filter for display realizing price-reduction by using a laminated body comprising only one piece of plastic film as a substrate (laminated body including conductive layer and functional layer besides that), and having electrodes capable of obtaining electric conduction to a display housing (outside electrode) easily and sufficiently, and its production method. Another object of the present invention is to provide a production method of display with the laminated body.

### Means to solve the Problems

The above objects of the present invention have been basically achieved by the following inventions, namely the following inventions (1) to (3).
(1) A filter for display, which is a laminated body comprising:
   a conductive layer having a conductive mesh,
   one plastic film disposed only in one side of said conductive layer, and
   a functional layer disposed at the viewing side relative to said conductive layer and plastic film and having at least one function selected from antireflection function, hard coat function and antiglare function,
   which has a cavity reaching at least the conductive layer, while penetrating through the functional layer from the surface of the functional layer side, in at least one part of the peripheral part of said laminated body.
(2) A production method of filter for display, comprising at least:
   a step for obtaining a laminated body comprising a conductive layer having a conductive mesh, one plastic film disposed only in one side of said conductive layer, and
   a functional layer disposed at the viewing side relative to said conductive layer and plastic film and having at least one function selected from antireflection function, hard coat function and antiglare function; and
   a step for forming a cavity reaching at least the conductive layer by irradiation with a laser on the surface of the functional layer side in at least one part of the peripheral part of said laminated body.
(3) A production method of display wherein
   a laminated body comprising a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function is mounted in a display so that the opposite surface of said functional layer is set to be the display side, then, irradiated with a laser on the surface of the functional layer side in at least one part of the peripheral part of the laminated body to form a cavity reaching at least the conductive layer.

### [Effect of the Invention]

The present invention can provide a filter for display which uses a laminated body that the number of plastic films used is reduced for price-reduction, and has electrodes that electric conduction to display housing is achieved easily and sufficiently. According to the present invention, since the number of layers constituting a filter for display becomes small by using only one piece of plastic film as a substrate and reducing the number of adhesive layers, reflection and scattering in layer boundary decrease, as a result, optical performance such as enhancement of contrast are improved.

### BRIEF DESCRIPTION OF THE DRAWINGS

Fig. 1 is a plan view of one example (constitution example A) of filter for display according to the present invention.
Fig. 2 is a pattern diagram of cross section of A-A in Fig. 1.
Fig. 3 is a plan view of another example of filter for display according to the present invention.
Fig. 4 is a pattern diagram of cross section of the cavity part of laminated body with a cover film according to the present invention.
Fig. 5 is a pattern diagram of cross section of the mode that a conductive material is disposed in a cavity part.
Fig. 6 is a plan view of another example (constitution example B) of filter for display according to the present invention.
Fig. 7 is a pattern diagram of cross section of A-A in Fig. 6.
Fig. 8 is a pattern diagram of cross section of another example of filter for display according to the present invention.
Fig. 9 is a plan view of another example of filter for display according to the present invention.
Fig. 10 is a pattern diagram of cross section of the cavity part of laminated body with a cover film according to the present invention.
Fig. 11 is a pattern diagram of cross section of the mode that a conductive material is disposed in a cavity part of Fig.10.
Fig. 12 is a pattern diagram of cross section of the mode that a cover film is detached from Fig. 11.

### Description of number and symbol

- 1, 11: Cavity
- 2, 12: Functional layer
- 3, 14: Conductive layer
- 4, 13: Plastic film
- 5, 16: Near-infrared ray shielding layer
- 6, 15, 17: Adhesive layer
- 7, 18: Cover film
- 8, 19: Conductive material

### BEST MODE FOR CARRYING OUT THE INVENTION

A laminated body constituting a filter for display of the present invention is a laminated body including a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function. Here, a functional layer being disposed at the viewing side relative to the conductive layer and plastic film means that when a filter for display is mounted in a display, a functional layer is disposed at a viewer side (outer air side) from the conductive layer and plastic film.

One preferable constitution example (A) of such laminated body of the present invention is a laminated body having a plastic film, a conductive layer and a functional layer in this order. Another preferable constitution example (B) is a laminated body having a conductive layer, a plastic film, and a functional layer in this order.

In regard to a laminated body used in a film for display of the present invention, a filter for display has preferably a laminated body that no adhesive layer lies between the conductive layer and plastic film, between the conductive layer and functional layer, and between plastic film and functional film.

Namely, as a laminated body of the constitution example (A), it is preferable that no adhesive layer lies between plastic film and conductive layer, and between conductive layer and functional layer.

In a laminated body of the constitution example (A), a functional film is preferably formed on a conductive layer by coating method.

In the constitution example (B), it is preferable that no adhesive layer lies between conductive layer and plastic film, and between plastic film and functional film.

Herein, an adhesive layer means a layer composed of a sticking material or an adhesive material. As described above, by laminating a conductive layer, plastic film and functional layer without interposing an adhesive layer, the number of layers constituting a filter for display becomes small, as a result, reflection and scattering in layer boundary decrease, and optical performance such as enhancement of contrast is improved.

Hereinafter, a laminated body constituting a filter for display of the present invention will be detailed.

In the present invention, a functional layer has at least one function selected from antireflection function, antiglare function and hard coat function. The functional layer may be constituted by a single layer or a plurality of layers, or may be a layer having a plurality of functions. Hereinafter, a layer having an antireflection function, antiglare function and hard coat function will be explained.

A layer having an antireflection function (reflection preventing layer) is to prevent a reflection and reception of outside light such as fluorescence light affecting image display of a display. The antireflection layer has preferably 5% or less in visual reflectance of surface, more preferably 4% or less, and particularly preferably 3% or less. The visual reflectance here is a visual reflectance (Y) that reflectance in a wavelength of visual region (380 to 780 nm) is measured using a spectrophotometer and calculated in accordance with CIE1931 system.

As such antireflection layer, it is preferable to use one that two or more layers are laminated so that a high refractive index layer and a low refractive index layer are present on a viewer side. Refractive index in a high refractive index layer is preferably in a range of 1.5 to 1.7, and particularly preferably in a range of 1.55 to 1.69. Refractive index in a low refractive index layer is preferably in a range of 1.25 to 1.49, and particularly preferably in a range of 1.3 to 1.45.

Examples of materials for forming a high refractive index layer include organic materials such as those obtained by polymerizing/hardening urethane (meth)acrylate, polyester (meth)acrylate, and the like, and those obtained by crosslinking/hardening crosslinkable resin raw materials such as silicone type, melamine type and epoxy type; and inorganic materials such as one containing mainly of indium oxide and containing a small amount of titanium oxide or the like therein, or Al2O3, MgO, and TiO2. Among them, organic materials are preferably used. Hereinafter, a preferable aspect of a high refractive index layer of the present invention will be explained.

In the present invention, a high refractive index layer can use a resin component such as an acrylic type resin, urethane type resin, melamine type resin, organic silicate compound, silicone type resin, phosphorous-containing type resin, sulfide-containing resin and halogen-containing resin, alone or in a mixed type thereof, in particular, a silicone type and an acrylic type resins are preferably used from the points of hardness and durability. Further, an acrylic type resin of an active energy ray hardening type, or an acrylic type resin of thermal hardening type is preferable from the points of hardenability, flexibility and productivity. In particular, a (meth)acrylate type resin is preferable because radical polymerization takes place easily by an active energy ray radiation to improve the chemical resistance and hardness of a film to be formed.

Examples of such (meth)acrylate type resin include (meth)acrylates with three functionalities such as pentaerythritol tri(meth)acrylate, trimethylol propane tri(meth)acrylate, glycerol tri(meth)acrylate, ethylene-modified trimethylol propane tri(meth)acrylate, and tris-(2-hydroxyethyl)-isocyanurate tri(meth)acrylate; (meth)acrylates with four or more functionalities such as pentaerythritol tetra(meth)acrylate, dipentaerythritol penta(meth)acrylate, and dipentaerythritol hexa(meth)acrylate.

A high refractive index layer can further use a (meth)acrylate compound (monomer) having an acidic functional group such as a carboxyl group, phosphoric group or a sulfonic acid group. Specifically, examples of monomer containing an acidic functional group include unsaturated carboxylic acids such as acrylic acid, methacrylic acid, crotonic acid, 2-(meth)acryloyloxyethyl succinic acid and 2-(meth)acryloyloxyethyl phthalic acid; (meth)acrylic phosphate such as mono(2-(meth)acryloyloxyethyl)acid phosphate, diphenyl-2-(meth)acryloyloxyethyl phosphate; and 2-sulfoester (meth)acrylate. In addition, a (meth)acrylate compound having a polar bond such as amide bond, urethane bond and ester bond can be used.

In a high refractive index layer, an initiator may be contained to promote hardening of a resin component coated. As the initiator, it is one that initiates or promotes polymerization and/or cross-linking reaction by radical reaction, anion reaction, cation reaction or the like of a resin component coated, and various light polymerization initiators conventionally known can be used.

Specific examples of such light polymerization initiator include sulfides such as sodium methyldithiocarbamate sulfide, diphenyl monosulfide, dibenzothiazoyl monosulfide and disulfide; thioxanthone derivatives such as thioxanthone, 2-ethylthioxanthone, 2-chlorothioxanthone and 2,4-diethylthioxanthone; azo compounds such as hydrazone and azobisisobutyronitrile; diazo compounds such as benzene diazonium salt; aromatic carbonyl compounds such as benzoin, benzoin methyl ether, benzoin ethyl ether, benzophenone, dimethylaminobenzophenone, Michler's ketone, benzyl anthraquinone, t-butyl anthraquinone, 2-methyl anthraquinone, 2-ethyl anthraquinone, 2-aminoanthraquinone and 2-chloroanthraquinone; dialkyl aminobenzoate such as methyl p-dimethyl aminobenzoate, ethyl p-dimethyl aminobenzoate, butyl D-dimethyl aminobenzoate and isopropyl p-dimethyl aminobenzoate; peroxide such as benzoyl peroxide, di-t-butyl peroxide, dicumyl peroxide and cumene hydroperoxide; acridine derivatives such as 9-phenylacridine, 9-p-methoxyphenylacridine, p-acetylamino acridine and benzacridine; phenazine derivatives such as 9,10-dimethylbenzphenazine, 9-methylbenzphenazine and 10-methoxybenzphenazine; quinoxaline derivatives such as 6,4',4"-trimethoxy-2,3-diphenylquinoxaline; 2,4,5-triphenylimidazoyl dimer, 2-nitrofluorene, 2,4,6-triphenyl pyrylium boron tetrafluoride salt, 2,4,6-tris(trichloromethyl)-1,3,5-triazine, 3,3'-carbonylbiscoumarine, thio-Michler's ketone, 2,4,6-trimethylbenzoyldiphenyl phosphine oxide, oligo(2-hydroxy-2-methyl-1-(4-(1-methylvinyl)phenyl)propane, 2-benzyl-2-dimethylamino-1-(4-morpholinophenyl)-butane, and the like.

In a high refractive index layer, an amine compound may be coexistent with a light polymerization initiator to prevent the lowering of sensitivity due to oxygen inhibition of the initiator. Such amine compound is not particularly limited as long as it is a nonvolatile one, for example, such as aliphatic amine compound and aromatic amine compound, and for example, triethanolamine, methyldiethanolamine and the like are preferable.

In a high refractive index layer, a fine particle of metal oxide may be contained. An antistatic effect is thus achieved. Examples of the fine particle of metal oxide preferably include tin-containing oxide particle (ATO), zinc-containing antimony oxide particle, tin-containing indium oxide particle (ITO), zinc oxide/aluminum oxide particle, and antimony oxide particle, more preferably tin-containing indium oxide particle (ITO) and tin-containing antimony oxide particle (ATO).

As such metal oxide particle, there is preferably used a particle of 0.5 µm or less in arithmetic average particle diameter (JIS Z8819-1 (year 1999) and Z8819-2 (year 2001)) calculated from a circle-equivalent diameter distribution based on an average particle diameter (specific surface area measured by BET method: JIS R1626 (year 1996)), a particle of 0.001 to 0.3 µm is more preferably, and a particle of 0.05 to 0.2 µm in particle diameter is further preferably used. If the average particle diameter exceeds 0.5 µm, there is a case that transparency of high refractive index layer is lowered, and if less than 0.001 µm, the particle tends to coagulate, so there is a case that haze value increases. The content of metal oxide particle in a high refractive index layer is preferably in a range of 0.1 to 20% by mass relative to 100% by mass of resin component.
Further, a high refractive index layer can contain various additives such as polymerization inhibitor, hardening catalyst, antioxidant and disperser.

The thickness of high refractive index layer in the case of not providing a hard coating layer is preferably in a range of 0.5 to 20 µm, and more preferably in a range of 1 to 10 µm.

A low refractive index layer constituting an antireflection layer can be composed of an organic material such as fluorine-containing polymer, partly or fully fluorinated alkyl ester of (meth)acrylic acid and fluorine-containing silicone, and an inorganic material such as MgF2, CaF2 and SiO2. Hereinafter, a preferable mode of a low refractive index layer will be exemplified.

As one preferable mode of a low refractive index layer, there are listed a method that a thin film of MgF2, SiO2 and the like is formed by a gas phase method such as vacuum deposition method, spattering and plasma CVD method, or a method that SiO2 gel film is formed from a sol solution containing SiO2 sol.

As another preferable mode of a low refractive index layer, a constitution consisting of mainly siloxane polymer obtained by bonding a silica type fine particle can be adopted. Additionally, "bonding" called here means that a silica component of silica type fine particle and a siloxane polymer of matrix are reacted to be a homogenized state. A siloxane polymer bonded with a silica type fine particle can be obtained by utilizing a known condensation reaction after a multifunctional silane compound in a solvent under the presence of the silica type fine particle once forms a silanol compound by an acid catalyst by using a known hydrolysis reaction.

As such multifunctional silane compound, it is preferable to contain a multifunctional fluorine-containing silane compound from the points of lower refractive index and antifouling property, and examples thereof include trifunctional fluorine-containing silane compounds such as trifluoromethyl methoxysilane, trifluoromethyl ethoxysilane, trifluoropropyl trimethoxysilane, trifluoropropyl triethoxysilane, heptadecafluorodecyl trimethoxysilane, tridecafluorooctyl trimethoxysilane, heptadecafluorodecyl triethoxysilane and tridecafluorooctyl triethoxysilane; difunctional fluorine-containing silane compounds such as heptadecafluorodecyl methyldimethoxysilane, and each is suitably used, from the viewpoint of surface hardness, trifluoromethyl methoxysilane, trifluoromethyl ethoxysilane, trifluoropropyl trimethoxysilane and trifluoropropyl triethoxysilane are more preferable.

As a multifunctional silane compound, a multifunctional fluorine-noncontaining silane compound can be used. Examples of such multifunctional fluorine-noncontaining silane compound include trifunctional silane compounds such as vinyl trimethoxysilane, vinyl triethoxysilane, 3-methacryloxypropyltrimethoxysilane, 3-methacryloxypropyltriethoxysilane, methyl trimethoxysilane methyl triethoxysilane, hexyl trimethoxysilane, octadecyl trimethoxysilane, octadecyl triethoxysilane, phenyl trimethoxysilane, phenyl triethoxysilane, 3-aminopropyltriethoxysilane, N-(2-aminoethyl)-3-aminopropylmethoxysilane, 3-chloropropyltrimethoxysilane, 3-(N,N-diglycidyl)aminopropyl trimethoxysilane and 3-glycidoxypropyltrimethoxysilane; difunctional silane compounds such as dimethyl dimethoxysilane, dimethyl diethoxysilane, diphenyl dimethoxysilane, diphenyl diethoxysilane, methylphenyl dimethoxysilane, methylvinyl dimethoxysilane, methylvinyl diethoxysilane, 3-glycidoxypropylmethyldimethoxysilane, 3-aminopropylmethyldimethoxysilane, N-(2-aminoethyl)-3-aminopropylmethyldimethoxysilane, 3-chloropropylpropyldimethoxysilane, 3-chloropropylmethyldimethoxysilane, cyclohexylmethyl dimethoxysilane, 3-methacryloxypropyldimethoxysilane and octadecyl methyldimethoxysilane; and tetrafunctional silane compounds such as tetramethoxysilane and tetraethoxysilane, and each is suitably used, from the viewpoint of surface hardness, vinyl trimethoxysilane, 3-methacryloxypropyltrimethoxysilane, methyl trimethoxysilane, methyl triethoxysilane, phenyl trimethoxysilane and phenyl triethoxysilane are preferable.

As the foregoing silica type fine particle, it is preferably a silica type fine particle of 1 nm to 200 nm in average particle diameter, particularly preferably 1 nm to 70 nm in average diameter. If the average particle diameter is less than 1 nm, bonding with a matrix material becomes insufficient and hardness sometimes deteriorates. On the other hand, if the average particle diameter is more than 200 nm, generation of space between particles generated by introducing many particles become few, the lowering effect of refractive index sometimes is not sufficiently exhibited. Further, among such silica type fine particles, one with a structure internally having voids is particularly preferably used because it lowers a refractive index.

The silica type fine particle internally having voids includes a silica type fine particle having a void part surrounded by an outer shell and a porous silica type fine particle having a lot of void parts, and each is suitably used. As such example, for instance, there is one which can be produced by a method disclosed in Japanese patent No. 3272111, and a volume occupied by a void inside a fine particle, namely, a void ratio of fine particle of 5% or more is preferable, and 30% or more is further preferable. The void ratio can be measured by using a mercury porosimeter (trade name: Pore analyzer 9320-PC2 manufactured by Shimadzu Corporation) for example. The refractive index of the fine particle itself is preferably 1.20 to 1.40, and more preferably 1.20 to 1.35. As such silica type fine particle, for example, there can be listed one disclosed in Japanese Unexamined Patent Publication No. 2001-233611, and a generally commercially available one based on Japanese Patent No. 3272111, and the like.

The thickness of low refractive index layer is preferably in a range of 0.01 to 0.4 µm, and more preferably in a range of 0.02 to 0.2 µm.

A layer having antiglare function (antiglare layer) is to prevent glare of image, and a film having a minute concavity and convexity on the surface is preferably used. As the antiglare layer, for example, there are used one that particles are dispersed in a heat hardening type resin or light hardening type resin, and coated and hardened on a support, or one that a heat hardening type resin or light hardening type resin is coated on a surface, a mold having a desired surface state is pressed thereon to form a concavity and convexity, then hardened. The antiglare layer preferably has a haze value (JIS K7136 (year 2000)) of 0.5 to 20%.

As the functional layer of the present invention, it is one preferable mode to use a layer having an antireflection function and an antiglare function simultaneously.

A layer having a hard coat function (hard coating layer) is provided for prevention of scar. Hardness of a hard coating layer is preferably high, and a pencil hardness defined by JIS K5600-5-4 (year 1999) is preferably 1 H or more, and more preferably 2 H or more. The upper limit is about 9H.

The hard coating layer can comprise an acrylic type resin, urethane type resin, melamine type resin, epoxy type resin, organic silicate compound, silicone type resin or the like. In particular, from the points of hardness and durability, a silicone type resin and an acrylic type resin are preferable. Further, from the points of hardenability, flexibility and productivity, one comprising an acrylic type resin of active energy ray hardening type or an acrylic type resin of heat hardening type is preferable.

The acrylic type resin of active energy ray hardening type or acrylic type resin of heat hardening type refers to a composition containing a multifunctional acrylate an acrylic oligomer or a reactive dilution agent as a polymerization hardening component. In addition, if necessary, one containing a light initiator, light sensitizer, thermal polymerization initiator or improving agent may be used.

Acrylic oligomer refers to one that a reactive acrylic group is bonded with the skeleton of acrylic type resin, and polyester acrylate, urethane acrylate, epoxy acrylate, polyether acrylate and the like, and one that an acrylic group is bonded with a rigid skeleton such as melamine and isocyanuric acid can also be used.

The reactive dilution agent refers to one which acts as a solvent as a medium of coating agent in a coating process and also has a group reacting with a monofunctional or multifunctional acrylic oligomer for itself to become a copolymerizable component for a coated film.

As a commercially available multifunctional acrylic type hardening coating material, the following products can be utilized: (trade name) "Diabeam (trademark) " series manufacture by Mitsubishi Rayon Co., Ltd., (trade name) "Denacol (trademark)" series manufacture by Nagase & Company Ltd., (trade name) "NK Ester" series manufacture by Shin-Nakamura Co., Ltd., (trade name) "UNIDIC (trademark) " series manufacture by DIC Corporation, (trade name) "Aronix (trademark)" series manufacture by Toagosei Co., Ltd., (trade name) "Blemmer (trademark)" series manufacture by NOF Corporation, (trade name) "KAYARAD (trademark)" series manufacture by Nippon Kayaku Co., Ltd., and (trade name) "Light Ester" series, "Light Acrylate" series manufacture by Kyoeisha Chemical Co., Ltd.

A typical example of an acrylic compound constituting a hard coating layer-forming composition includes mainly a mixture comprising at least one kind of a monomer and prepolymer having 3 or more (meth)acryloyloxy groups in a molecule, more preferably 4 or more, further preferably 5 or more, and at least one kind of monomer having an ethylenically unsaturated double bond of 1 to 2 in a molecule, and a hard coat layer obtained by active energy ray hardening or heat hardening is preferably used from the points of excellent hardness, abrasion resistance and flexibility. If a (meth) acryloyloxy group is contained too much, a monomer becomes high viscosity, so it becomes difficult to handle, causing a high molecular weight, and it becomes difficult to use as a coating liquid, thus (meth)acryloyloxy groups in a molecule are preferably 10 or less.

As a monomer and prepolymer having 3 or more (meth)acryloyloxy groups in a molecule, a compound that the hydroxyl group of a polyhydric alcohol having 3 or more alcoholic hydroxyl groups in a molecule is converted to esters with 3 or more (meth)acrylates can be listed. As a specific example, there can be used pentaerythritol tri (meth) acrylate, pentaerythritol tetra(meth)acrylate, dipentaerythritol tri(meth)acrylate, dipentaerythritol tetra(meth)acrylate, dipentaerythritol penta(meth)acrylate, dipentaerythritol hexa(meth)acrylate, trimethylol propane tri(meth)acrylate, pentaerythritol triacrylate hexamethylene diisocyanate urethane prepolymer, pentaerythritol triacrylate toluene diisocyanate urethane prepolymer, pentaerythritol triacrylate isophorone diisocyanate urethane prepolymer and the like. These monomer and prepolymer can be used in one kind, or a mixture of two kinds or more. In particular, among them, a multifunctional acrylate compound having at least one hydroxyl group is particularly preferable because adhesiveness of a hard coating layer and the adjacent layer can be improved by a concomitant use of isocyanate described below.

The use ratio of these monomer and prepolymer having 3 or more (meth)acryloyloxy groups in a molecule is preferably 20 to 90% by mass relative to the total amount of hard coating layer forming composition, more preferably 30 to 80% by mass, and most preferably 30 to 70% by mass.

If the use ratio of the monomer and prepolymer having 3 or more (meth) acryloyloxy groups in a molecule is less than 20% by mass relative to the total amount of hard coating layer forming composition, it is sometimes insufficient in the point of obtaining a hardened coat having a sufficient abrasion resistance. If the use ratio of the monomer and prepolymer having 3 or more (meth) acryloyloxy groups in a molecule is more than 90% by mass relative to the total amount of hard coating layer forming composition, there is a disadvantageous case that shrinkage due to hardening is large, deformation is left in hardened coat, flexibility of the coat deteriorates, and the coat curls markedly at a hardened coat side.

Among them, the use ratio of the multifunctional acrylate compound having at least one hydroxyl group is preferably 10 to 80% by mass relative to the total amount of hard coating layer forming composition, more preferably 20 to 70% by mass, and most preferably 30 to 60% by mass. If the use ratio of the multifunctional acrylate compound having at least one hydroxyl group is less than 10% by mass relative to the total amount of hard coating layer forming composition, there is a case that an effect on improving adhesiveness of a hard coating layer and the adjacent layer is small. If the use ratio of the multifunctional acrylate compound having at least one hydroxyl group is more than 80% by mass relative to the total amount of hard coating layer forming composition, there is a case that crosslink density in a hard coating layer is lowered and hardness of a hard coating layer tends to be lowered.

Next, regarding a monomer having an ethylenically unsaturated bond of 1 to 2 in a molecule, it can be used without a particular limitation as long as it is an ordinary monomer with a radically polymerizable property.

As a compound having two ethylenically unsaturated bonds in a molecule, a (meth) acrylate of the following (a) to (f) can be used.

Namely, (a) (meth)acrylic acid diesters of alkylene glycol having 2 to 12 carbon atoms: ethylene glycol di(meth)acrylate, propylene glycol di(meth)acrylate, 1,4-butanediol di(meth)acrylate, neopentyl glycol di(meth)acrylate, 1,6-hexanediol di(meth)acrylate and the like;
(b) (meth)acrylic acid diesters of polyoxyalkylene glycol: diethylene glycol di(meth)acrylate, triethylene glycol di(meth)acrylate, tetraethylene glycol di(meth)acrylate, dipropylene glycol di(meth)acrylate, polyethylene glycol di(meth)acrylate, polypropylene glycol di(meth)acrylate and the like;
(c) (meth)acrylic acid diesters of polyhydric alcohol: pentaerythritol di(meth)acrylate and the like;
(d) (meth) acrylic acid diesters of bisphenol A, or ethylene oxide and propylene oxide adduct of hydride of bisphenol A: 2,2'-bis(4-acryloxyethoxyphenyl)propane, 2,2'-bis(4-acryloxypropoxyphenyl)propane and the like;
(e) urethane (meth)acrylates having two (meth) acryloyloxy groups in a molecule obtained in such manner that a terminal isocyanate group-containing compound obtained by previously reacting a diisocyanate compound with a compound containing 2 or more alcoholic hydroxyl groups is further reacted with an alcoholic hydroxyl group-containing (meth)acrylate , and the like; and
(f) epoxy (meth)acrylates having two (meth)acryloyloxy groups in a molecule obtained by reacting a compound having two or more epoxy groups in a molecule with acrylic acid or methacrylic acid, and the like.

As a compound having one ethylenically unsaturated bond in a molecule, there can be used methyl (meth)acrylate, ethyl (meth)acrylate, n- and i-propyl (meth) acrylate, n-, sec-, and t-butyl (meth)acrylate, 2-ethylhexyl (meth)acrylate, lauryl (meth)acrylate, stearyl (meth)acrylate, methoxyethyl (meth)acrylate, ethoxyethyl (meth)acrylate, hydroxyethyl (meth)acrylate, polyethylene glycol mono(meth)acrylate, polypropylene glycol mono(meth)acrylate, glycidyl (meth)acrylate, tetrahydrofurfuryl (meth)acrylate, N-hydroxyethyl (meth)acrylate, N-vinylpyrrolidone, N-vinyl-3-methylpyrrolidone, N-vinyl-5-methylpyrrolidone and the like. These monomers may be used in one kind, or mixture of two or more kinds.

The use ratio of the monomer having one or two ethylenically unsaturated bonds in a molecule is preferably 10 to 50% by mass relative to the total amount of hard coating layer forming composition, and more preferably 20 to 40% by mass. If the use ratio of the monomer having one or two ethylenically unsaturated bonds in a molecule is more than 50% by mass relative to the total amount of hard coating layer forming composition, there is a case that a hardened coat with sufficient abrasion resistance tends to be difficult to obtain. If the use ratio of the monomer having one or two ethylenically unsaturated bonds in a molecule is less than 10% by mass relative to the total amount of hard coating layer forming composition, there is a case that flexibility of hardened coat deteriorates, and adhesiveness to a laminated film provided on a substrate film is lowered.

In the present invention, as a method for hardening a hard coating forming composition, for example, a method of irradiating ultraviolet as an active energy ray, a method of heating at high temperature and the like can be used. In the case of using these methods, it is desirable to add a light polymerization initiator or thermal polymerization initiator to the hard coating layer forming composition.

As a specific example of the light polymerization initiator, there can be used carbonyl compounds such as acetophenone, 2,2-diethoxyacetophenone, p-dimethyl acetophenone, p-dimethyl aminopropiophenone, benzophenone, 2-chlorobenzophenone, 4,4'-dichlorobenzophenone, 4,4'-bisdiethylaminobenzophenone, Michler's ketone, benzyl, benzoin, benzoin methyl ether, benzoin ethyl ether, benzoin isopropyl ether, methyl benzoyl formate, p-isopropyl-α-hydroxyisobutylphenone, α-hydroxyisobutylphenone, 2,2-dimethoxy-2-phenylacetophenone and 1-hydroxycyclohexyl phenyl ketone; and sulfur compounds such as tetramethyl thiuram monosulfide, tetramethyl thiuram disulfide, thioxanthone, 2-chlorothioxanthone and 2-methylthioxanthone. These light polymerization initiators may be used alone, or in a mixture of two kinds or more. As the thermal polymerization initiator, peroxide compounds such as benzoyl peroxide or di-t-butyl peroxide can be used.

The use amount of the light polymerization initiator or thermal polymerization initiator is suitably 0.01 to 10% by mass relative to the total amount of hard coating layer forming composition. If electron beam or gamma ray is a hardening means, a polymerization initiator is not necessarily added. If heat hardening is conducted at a high temperature of 220°C or more, a thermal polymerization initiator is not necessarily added.

As the hard coating layer forming composition in the present invention, it is preferable to contain a polyisocyanate compound. Examples of the polyisocyanate compound include at least dimer or higher one such as 2,4- and/or 2,6-tolylene diisocyanate, 4,4 ' -diphenylmethane diisocyanate (MDI), polymeric MDI, 1,5-naphthylene diisocyanate, toluidine diisocyanate, 1,6-hexamethylene diisocyanate (HDI), trimethylhexamethylene diisocyanate, isophorone diisocyanate, xylene diisocyanate (XDI), hydrogenated XDI, hydrogenated MDI, lysine diisocyanate, triphenylmethane triisocyanate and tris(isocyanatephenyl)thiophosphate. These polyisocyanate compounds can be used alone, or in mixture of two kinds or more.

These polyisocyanate compounds and/or the derivatives are mixed with the foregoing hard coating layer forming composition and coated. The compounding quantity of the polyisocyanate compound and/or the derivative thereof is preferably 0.5 to 50% by mass relative to the total amount of hard coating layer forming composition, more preferably 1 to 30% by mass, and further preferably 3 to 20% by mass from the points of adhesion, surface hardness, resistance to moist heat, and reduction of iris pattern. If the compounding quantity of the polyisocyanate compound and/or the derivative thereof is less than 0.5% by mass relative to the total amount of hard coating layer forming composition, there is a case that an effect of adhesion improvement is not sufficient, and reduction of iris pattern is insufficient, whereas if the compounding quantity of the polyisocyanate compound and/or the derivative thereof is more than 50% by mass relative to the total amount of hard coating layer forming composition, there is a case that surface hardness deteriorates.

Regarding the hard coating layer forming composition that the polyisocyanate is added, it is also preferable to contain an organic metal catalyst for enhancing the hardening efficiency.

Examples of the organic metal catalyst include, but not particularly limited, an organic tin compound, organic aluminum compound, and organic 4A group element (titanium, zirconium or hafnium) compound, but from the consideration of safety, one selected from an organic zirconium compound, an organic aluminum compound and an organic titanium compound being a non-tin type metal catalyst is preferably adopted. Examples of organic tin compound can include dibutyltin fatty acid salts such as tetrabutyltin, tetraoctyltin, dibutyltin dichloride and dibutyltin dilaurate; and dioctyltin fatty acid salts such as dioctyltin dilaurate.

As the organic zirconium compound, organic aluminum compounds, organic hafnium compounds and organic titanium compounds, reaction products of ortho-ester of these metals and β-ketoester (β diketone) are exemplified, specifically, there can be listed reaction products of: metal ortho-ester such as zirconium tetra-n-propoxide zirconium tetraisopropoxide, zirconium tetra-n-butoxide, titanium tetra-n-butoxide, titanium tetraisopropoxide, titanium tetra-n-butoxide, aluminum tetra-n-propoxide, aluminum tetraisopropoxide and aluminum tetra-n-butoxide; and β-ketoester (β diketone) such as acetylacetone, methyl acetate, ethyl acetoacetate, n-propyl acetoacetate, isopropyl acetoacetate and t-butyl acetoacetate. The mixing mole ratio of metal ortho-ester and β-diketoester (β diketone) is preferably about 4 : 1 to 1 : 4, and more preferably 2 : 1 to 1 : 4. If metal ortho-ester is more than 4 : 1, reactivity of catalyst is too high and the pot life tends to become short, if β-diketoester is more than 1 : 4, catalyst activity deteriorates, which is not preferable mode. The compounding quantity of the metal type catalyst is preferably 0.001 to 10% by mass relative to the total amount of hard coating forming composition, more preferably 0.01 to 5% by mass, and further preferably 0.01 to 2% by mass. If the compounding quantity of the metal type catalyst is less than 0.001% by mass relative to the total amount of hard coating forming composition, an effect of catalyst addition is low, whereas if more than 10% by mass, it is not preferable from the economical point of view.

As a preferable aspect of the hard coating layer forming composition, it is preferably in a range of 10 to 80% by mass of a multifunctional acrylate compound having at least one hydroxyl group, 1 to 30% by mass of an isocyanate compound, and 0.001 to 10% by mass of an organic metal type, if necessary, relative to the total amount of hard coating forming composition. Further, if necessary, a monomer having one or two ethylenically unsaturated bonds may be added by 0% by mass to 50% by mass or less.

In the present invention, various kinds of additives can be further optionally compounded in a hard coating layer within a range not damaging the effect of the present invention is not damaged. For example, stabilizers such as antioxidant, light stabilizer and ultraviolet absorber, surfactants, leveling agents, antistatic agents and the like can be used.

A silicone type leveling agent is preferably one that polydimethylsiloxane is a basic skeleton and a polyoxyalkylene group is added, and a dimethylpolysiloxane-polyoxyalkylene copolymer (for example, SH190 manufactured by Dow Corning Toray Co., Ltd.) is suitable.

In the case of further providing a laminate film on a hard coating layer, it is preferable to adopt an acrylic type leveling agent not damaging adhesion. As such leveling agent, there can be preferably used "ARUFON-UP1000 series, UH2000 series, UC3000 series (trade name) manufactured by Toagosei Co., Ltd. and the like. The addition amount of the leveling agent is desirably in a range of 0.01 to 5% by mass relative to the total amount of hard coating forming composition.

As an active energy ray used in the present invention, electromagnetic waves enabling polymerization of an acrylic type vinyl group are listed, such as ultraviolet, electron beam and radioactive rays (α ray, β ray, y ray, etc.), practically, ultraviolet is convenient and preferable. As an ultraviolet source, ultraviolet fluorescence light, low-pressure mercury lamp, high-pressure mercury lamp, super high-pressure mercury lamp, xenon lamp, carbon arc lamp, and the like can be used. When an active ray is irradiated, hardening can be efficiently done by radiation under a low oxygen concentration. Further, although an electron beam system needs expensive equipment and an operation under inert gas, it is advantageous from the point that neither light polymerization initiator nor light sensitizer needs to be contained in a coating layer.

As the heat necessary for thermal hardening used in the present invention, heat given by which air or inert gas heated with a steam heater, electric heater, infrared heater, far-infrared heater or the like up to at least 140°C or more is blown on a substrate or coat film with a slit nozzle is listed, above all, heat by air heated at 200°C or more is preferable, and heat by nitrogen heated at 200°C or more is further preferable because of fast hardening speed.

The thickness of hard coating layer is preferably 0.5 to 20 µm, and more preferably 1 to 10 µm. If the thickness of hard coating layer is less than 0.5 µm, since it is too thin even though it is sufficiently hardened, surface hardness is not sufficient and the surface tends to be scared. On the other hand, if the thickness of hard coating layer is more than 20 µm, a hardened film tends to be cracked due to stress of folding and the like.

A hard coating layer can be provided with a function as a high refractive index layer constituting the foregoing antireflection layer. Enhancing the refractive index of hard coating layer is done by adding superfine particles of high refractive index metal or metal oxide into a hard coating layer forming composition, or by using a resin containing molecules or atoms of high refractive index component.

The superfine particles of a high refractive index preferably has its particle diameter of 5 to 50 nm and refractive index of about 1.65 to 2.7, specifically, for example, listed are superfine particles such as ZnO (refractive index 1.90), TiO2 (refractive index 2.3 to 2.7), CeO2 (refractive index 1.95), Sb2O5 (refractive index 1.71), SnO2, ITO (refractive index 1.95), Y2O3 (refractive index 1.87), La2O3 (refractive index 1.95), ZrO2 (refractive index 2.05) and A12O3 (refractive index 1.63).

As the molecules and atoms contained in a resin for improving a refractive index, halogen atoms except for F, atoms S, N and P, and aromatic rings are listed.

A filter for display of the present invention is characterized by having a cavity reaching at least the conductive layer, while penetrating through the functional layer from the surface of the functional layer side, in at least one part of the peripheral part of said laminated body to draw an electrode from the conductive layer. Further, the filter for display of the present invention forms a cavity in the peripheral part of the laminated body to draw an electrode from the conductive layer, as described below, preferably forms a cavity through burnout/evaporation of the functional layer by using laser, so the functional layer is preferably made in a constitution capable of burnout/evaporation by laser irradiation. Therefore, the functional layer is preferably a composition containing an organic material, and an organic material such as a resin is preferably contained by 30% by mass or more relative to the total components constituting a functional layer, more preferably contained by 50% by mass or more, and particularly preferably contained by 70% by mass or more.

As described above, the functional layer of the present invention may be a single layer or a plurality of layers. As a functional layer of a plurality of constitutions, there are exemplified a) hard coating layer/high refractive index layer/low refractive index layer; b) high refractive index hard coating layer/low refractive index layer; c) hard coating layer/antiglare layer; d) hard coating layer/antiglare antireflection layer, and the like. In the constitutions a) to d), a layer described at the right side is disposed at the viewing side.

In the case that the functional layer is a single layer, it is preferable to have a plurality of functions simultaneously. As an example of such single layer, there are exemplified e) antireflection hard coating layer (single layer having antireflection function and hard coat function), f) antiglare hard coating layer (single layer having antiglare function and hard coat function), g) antiglare antireflection hard coating layer (single layer having antiglare function, antireflection function and hard coat function), h) antiglare antireflection layer (single layer having antiglare function and antireflection function), and the like.

One preferable constitution example (A) of the laminated body of the present invention has a plastic film, a conductive layer and a functional layer in this order. The laminated body of this constitution example (A) is preferably formed by directly coating a functional layer on a conductive layer. To coat/form a functional layer on a conductive layer not causing troubles such as coating irregularity, the total thickness of the functional layer is preferably larger than that of the conductive layer described below, the total thickness of the functional layer relative to the thickness of the conductive layer is preferably 130% or more, and more preferably 150% or more. The upper limit is about 2000%. By making the total thickness of the functional layer relative to the thickness of the conductive layer large, it is possible to sufficiently bury a concave and convex surface of conductive mesh and homogenize it. The total thickness of the functional layer is preferably in a range of 1 to 20 µm, and more preferably in a range of 2 to 10 µm. If the thickness of the functional layer becomes large exceeding 20 µm, resulting from production efficiency worsened due to the lowering of coating speed, drying speed or hardening speed and increase in raw material costs, it becomes difficult to realize price-reduction of a primary purpose of the present invention. If the thickness of the functional layer becomes large, there is a case causing disadvantage that the functional layer itself tends to be cracked. If the thickness of the functional layer becomes less than 1 µm, there is a case that it becomes difficult to obtain a uniform coated surface and the original function as a functional layer cannot be exhibited.

As a coating method to coat/form the functional layer, a known wet coating method can be used such as dip coating method, spin coat method, slit die coat method, gravure coat method, reverse coat method, rod coat method, bar coat method, spray method and roll coating method.

The conductive layer of the present invention is a layer for shielding electromagnetic waves generated from display, and comprising conductive mesh. The surface resistance value of conductive layer is preferably lower, preferably 10 Ω/□ or less, more preferably 5 Ω/□ or less, and particularly preferably 3 Ω/□ or less. The lower limit of surface resistance value is about 0.01 Ω/□. The surface resistance value of conductive layer can be measured by a four terminal method. The conductive layer having conductive mesh has a merit of obtaining a low surface resistance value in comparison with a metal film formed by a spattering method or vacuum deposition method, or a conductive layer comprising conductive filler and resin binder. In particular, it is difficult to obtain a low surface resistance value desired in the present invention by a conductive layer comprising conductive filler and resin binder. To form a metal thin film by a spattering method or vacuum deposition method, a large-scale apparatus is required, and there is a problem that high productivity is not obtained.

In the case of a laminated body of constitution example (A) having a functional layer on a conductive layer, conductive mesh is preferable also from the viewpoints of adhesion (adhesive force) for a functional layer to be laminated on a conductive layer. In the constitution example (A) of the present invention, although coating/forming a functional layer on a conductive layer is preferable from the viewpoint of productivity, when a functional layer with a different composition is coated/formed on a metal thin film formed by a spattering method or vacuum deposition method, there is a case that adhesion becomes insufficient and the functional layer exfoliates.

On the contrary, as for the conductive mesh, the surface resistance value of 10 Ω/□ or less described above is easily obtained, a functional layer and a plastic film as a substrate are contacted through openings of conductive mesh, so it is possible to ensure a sufficient adhesion between the functional layer and plastic film. In the case of conductive mesh, for not lowering transmittance of a filter for display, it is preferably to design for the opening ratio to be 70% or more (wherein, the opening ratio of conductive mesh means a ratio of area occupied by the opening part to the projected area of conductive mesh), therefore, a contact area between a functional layer coated on a conductive layer comprising conductive mesh and a conductive layer is very small, so the problem of adhesion is not posed.

In the case of constitution example (A) coating/forming a functional layer on a conductive layer, the thickness of conductive layer (conductive mesh) is preferably lower from the viewpoint of coatability of functional layer, the thickness of conductive layer (conductive mesh) is preferably 6 µm or less. If the thickness of conductive layer (conductive mesh) becomes large exceeding the above-described range, concavity and convexity of the surface of conductive layer becomes large and smoothness deteriorates, so there is a case that the coatability of functional layer deteriorates. The lower limit of the thickness of the conductive layer (conductive mesh) is preferably 0.2 µm or more from the viewpoint of electromagnetic shielding performance, and more preferably 0.3 µm or more.

The line width and line pitch of conductive mesh are designed for the opening ratio to be more than 70% or more, the line width is preferably 5 to 40 µm, and the line pitch is preferably in a range of 100 to 500 µm.

As a method for obtaining conductive mesh, a method generally conventionally used where a metal foil film such as copper foil is etched can be adopted. This method is a method where on a metal film-laminated film that a metal foil film such as copper foil is bonded on a plastic film via adhesive material, an etching resist pattern is produced by using a photolithography method or screen printing method, then, the metal foil film is etched. Example of the etching method includes a chemical etching method. The chemical etching is a method that an unnecessary conductor other than a protected conductive part with an etching-resist is dissolved with an etching liquid and removed. Examples of the etching liquid include aqueous ferric chloride, aqueous cupric chloride and alkali etching liquid.

The photolithography method is a method that a photosensitive layer photosensitive to radiation of ultraviolet or the like is provided on the metal film of a metal film-laminated film, this photosensitive layer is pattern-exposed using a photomask or the like, and developed to form a resist-pattern, next, the metal foil film is etched to form a conductive mesh, and lastly the resist is detached.

In the case of constitution example (A) coating/forming a functional layer on a conductive layer, conductive mesh is preferably formed on a plastic film not via adhesive layer. Here, an adhesive layer means a layer composed of a sticking material or adhesive material. When an adhesive layer lies between a conductive layer and a plastic film, smoothness of the surface of conductive layer further deteriorates, and a coatability of functional layer sometimes deteriorates. Moreover, by directly forming conductive mesh on a plastic film not via adhesive layer, a major part of the functional layer coated/formed on conductive mesh comes to contact with plastic, thus adhesion between a plastic film and a functional layer is improved by using a functional layer containing the foregoing resin. To improve adhesion between a plastic film and a functional layer, it is preferable to use a plastic film having an undercoat layer (primer layer).

Examples of a method for forming conductive mesh on a plastic film not via adhesive layer include 1) a method of etching a metal thin film, 2) a method of plating on a printed pattern, 3) a method using photosensitive silver salt, 4) a method of developing after metal film is formed on a printed pattern, and 5) a method of conducting laser abrasion of metal thin film. Hereinafter, each method will be explained in detail.
1) A method of etching a metal thin film is a method that a metal thin film is formed on a plastic film not via adhesive layer comprising a sticking material or adhesive material, on this metal thin film, an etching pattern is produced by using a photolithography method or screen printing method, then, the metal thin film is etched. Formation of metal thin film can be performed using a known method of spattering, ion platting, vacuum deposition, or plating a metal (for example, silver, gold, palladium, copper, indium, tin, or an alloy of silver with a metal other than itself).

The photolithography method is a method that a photosensitive layer photosensitive to radiation of ultraviolet or the like is provided on a metal thin film, this photosensitive layer is pattern-exposed using a photomask or the like, and developed to form a resist-pattern, next, the metal thin film is etched to form a conductive mesh, lastly the resist is detached.

The screen printing method is a method that an etching-resist ink is patter-printed on the surface of a metal thin film, and hardened, then, subjected to etching treatment to form a conductive mesh, thereafter the resist is detached.

As the etching method, there is a chemical etching method or the like. The chemical etching is a method that an unnecessary conductor other than a protected conductive part with an etching-resist is dissolved with an etching liquid and removed. Examples of the etching liquid include aqueous ferric chloride, aqueous cupric chloride and alkali etching liquid.
2) A method of plating on a printed pattern is a method that a mesh pattern is printed on a plastic film with a catalyst ink or the like, and a metal plating is conducted thereon. As one method thereof, a mesh pattern is printed using a catalyst ink composed of paste containing palladium colloid, and this is immersed in a non-electrolytic copper plating solution to provide non-electrolytic copper plating, subsequently, which is provided with electrolytic copper plating, further provided with electrolytic plating of Ni-Sn alloy, thereby to form a conductive mesh pattern.
3) A method using photosensitive silver salt is a method that a silver salt emulsion layer such as silver halide is coated on a plastic film, and photomask-exposed or laser-exposed, then, subjected to developing treatment to form a mesh of silver. The silver mesh formed is preferably plated further with a metal such as copper and nickel. This method is described in WO 2004/7810, Japanese Unexamined Patent Publication Nos. 2004-22156 and 2006-12935, which can be referred.
4) A method of developing after a metal film is formed on a printed pattern is a method that a reverse pattern to a mesh pattern is printed on a plastic film with a detachable resin, and a metal thin film is formed on the printed pattern in the same way as 1), then, developed, the resin and the metal film thereon are detached, thereby to form a mesh pattern of metal. As the detachable resin, a resin or resist resolvable in water, an organic solvent or alkali can be used. This method is described in Japanese Unexamined Patent Publication Nos. 2001-185834, 2001-332889, 2003-243881, 2006-140346 and 2006-156642, which can be referred.
5) A method of conducting laser abrasion of metal thin film is a method that in a metal thin film formed on a plastic film in the same way as 1), metal mesh is produced by laser abrasion method.

Laser abrasion is, in the case that laser beam with high energy density is irradiated on a solid surface absorbing laser beam, a phenomenon that bond between molecules in the irradiated part is broken and evaporated, resulting in abrading the solid surface in the irradiated part. By using this phenomenon, the solid surface can be processed. Since laser beam is high in going-straight property and light-condensing property, it is possible to selectively process an area as fine as about 3 times of wavelength of laser beam used in abrasion, and to obtain a high processing accuracy by the laser abrasion method.

For such laser used in abrasion, all lasers of wavelengths that a metal absorbs can be used. For example, a gas laser, semiconductor laser, excimer laser, or solid laser that semiconductor laser is used as an excitation light source can be used. There can be used a second harmonic generation (SHG), a third harmonic generation (THG) and a fourth harmonic generation (FHG) obtained in combination of the solid laser and a nonlinear optical crystalline.

Among such solid lasers, from the viewpoint of not processing a plastic film, it is preferable to use an ultraviolet laser with a wavelength of 254 nm to 533 nm. Above all, ultraviolet laser of SHG (wavelength 533 nm) of solid laser such as Nd:YAG (neodymium: yttrium· aluminum· garnet) is preferably used, and THG (wavelength 355 nm) of solid laser such as Nd:YAG is further preferably used.

As an oscillation method of such laser, although laser of all methods can be used, from the point of processing accuracy, pulse laser, further desirably, pulse laser of Q switch method with pulse width of ns or less is preferably used.

After a metal oxide layer of 0.01 to 0.1 µm is further formed on a metal thin film (viewing side), laser abrasion of the metal thin film and metal oxide layer is preferably carried out. As the metal oxide, there can be used metal oxides of copper, aluminum, nickel, iron, gold, silver, stainless steel, chromium, titanium, tin or the like, but from the points of price and stability of film, copper oxide is preferable. As a method of forming metal oxide, a vacuum deposition method, spattering method, ion plating method, chemical vapor deposition method, non-electrolytic and electrolytic plating, and the like can be used. The methods 1) to 5) can form conductive mesh on a plastic film not via adhesive layer, and produce a conductive mesh of 6 µm or less in thickness, so that it is preferable to coat/form a functional layer directly on a conductive layer.

As the mesh pattern of conductive mesh usable in the present invention, a lattice-like pattern, a pattern consisting of polygon of pentagon or more, a circular patter, or a combined pattern thereof are listed, further, a random pattern is preferably used as well.

In the present invention, conductive mesh is preferably subjected to blacking treatment. The blacking treatment can be done by oxidation treatment or black printing. For example, the methods described in Japanese Unexamined Patent Publication Nos. 10-41682 (1998), 2000-9484 and 2005-317703 can be used. The blacking treatment is preferably conducted on the surface at the viewing side and both side faces of conductive mesh, further, the blacking treatment is preferably conducted on both surfaces and both side faces of conductive mesh.

To produce a laminated body used in a filter for display in a continuous production line efficiently, the conductive mesh is preferably a continuous mesh. The continuous mesh means that a mesh pattern is formed without interruption, for example, in the case that a laminated body at least having a conductive layer with conductive mesh is produced in a long roll shape, the mesh is to be continuously formed in a roll-winding direction. By using such continuous mesh, when the laminated body of a roll shape is cut to produce a filter for display in a sheet shape, yield and productivity are improved. When conductive mesh is a continuous mesh, there are merits that it is easily adapted to displays with various sizes, and when defects occur in a production process of filter for display, it gets off with disposal of the amount limited to the defect parts. In particular, for a laminated body of constitution example (A), it is preferable to continuously coat a functional layer on a conductive layer having conductive mesh, therefore, production efficiency is greatly improved by using the continuous mesh as a conductive layer.

In the filter for display of the present invention, one piece of plastic film is used only on one side of a conductive layer. Examples of a resin constituting such plastic film include polyester resins such as polyethylene terephthalate and polyethylene naphthalate; cellulose resins such as triacetyl cellulose; polyolefin resins such as polyethylene, polypropylene and polybutylene; an acrylic resin, polycarbonate resin, ARTON resin, epoxy resin, polyimide resin, polyetherimide resin, polyamide resin, polysulfone resin, polyphenylenesulfide resin, and polyethersulfone resin. Among them, polyester resins, polyolefin resins and cellulose resins are preferable, and polyester resins are particularly preferably used. The thickness of plastic film is suitably in a range of 50 to 300 µm, but from the viewpoints of cost and of ensuring rigidity of filter for display, a range of 90 to 250 µm is particularly preferable.

The plastic film used in the present invention is preferably provided with an undercoat layer (primer layer) in order to strengthen adhesion (adhesive strength) to a near-infrared ray shielding layer described below.

In the filter for display of the present invention, it is preferable to position a functional layer on the outermost surface at the viewing side, an antifouling layer or the like being ultrathin film can be provided further on the functional layer without damaging the function of functional layer. The antifouling layer is a layer for preventing attachment of oily materials resulting from touching a filter for display with fingers, attachment of dirt, and dust in atmosphere, or for easily removing these attachments even when they adhere. As such antifouling layer, for example, a fluorine type coating agent, silicone type coating agent, silicone/fluorine type coating agent and the like are used. The thickness of the antifouling layer is preferably in a range of 1 to 10 nm.

In the filter for display of the present invention, it is preferable to further provide a layer having at least one function selected from near-infrared ray shielding function, color tone adjusting function and visible light transmittance adjusting function.

Regarding a near-infrared ray shielding function, it is preferable to adjust the maximum value of light transmittance in a wavelength range of 800 to 1100 nm to be 15% or less. The near-infrared ray shielding function may be provided by mixing and dispersing a near-infrared ray absorbing agent in a plastic film, a functional layer or an adhesive layer described below, or newly providing a near-infrared ray shielding layer. The near-infrared ray shielding function can also be provided by using a near-infrared ray absorbing agent, or providing a layer reflecting a near-infrared ray by a free electron of metal, like a conductive thin film. In the present invention, there is preferably used a mode of using a near-infrared ray shielding layer formed by coating/drying a coating material that a near-infrared ray absorbing agent is dispersed or dissolved in a resin binder, or containing the near-infrared ray absorbing agent in a functional layer or an adhesive layer. As the near-infrared ray absorbing agent, there can be used organic near-infrared ray absorbing agents such as phthalocyanine type compound, anthraquinone type compound, dithiol type compound and diimonium type compound; or inorganic near-infrared ray absorbing agents such as titanium oxide, zinc oxide, indium oxide, tin oxide, zinc sulfide and cesium-containing tungsten oxide.

In the case of newly providing the near-infrared ray shielding layer, it can be provided by coating/forming it between a plastic film and a conductive layer, or on a plastic film in the surface opposite to a conductive layer based on a plastic film.

In the case of providing a near-infrared ray shielding function at the viewing side from a plastic film, it is preferable to use an inorganic near-infrared ray absorbing agent of excellent weather resistance.

The color tone adjusting function is a function for absorbing a light with a specific wavelength emitted from display and enhancing color purity and whiteness. In particular, it is preferable to shield an orange light lowering color purity of red emission, and contain a pigment having the absorption maximum in a wavelength range of 580 to 620 nm. Further, for enhancing whiteness, it is preferable to contain a pigment having the absorption maximum in a wavelength range of 480 to 500 nm. For the color tone adjusting function, a layer containing a pigment absorbing a light within the wavelength range may be newly provided, or a pigment may be contained in the near-infrared ray shielding layer, functional layer or adhesive layer.

The visible light transmittance adjusting function is a function for adjusting transmittance of visible light, and it can be adjusted by containing a dye or a pigment. The visible light transmittance adjusting function may be provided in a plastic film, a near-infrared ray shielding layer, functional layer or adhesive layer, or a transmittance adjusting function layer may be newly provided.

In the case where layers having the color tone adjusting function and visible light transmittance adjusting function are each provided newly, these layers can be provided between a plastic film and a conductive layer, or on the surface opposite to a conductive layer based on a plastic film.

The filter for display of the present invention can be mounted in a display directly, or via known substrates with high rigidity, such as glass plate, acrylic plate, and polycarbonate plate. For a filter for display, it is preferable to provide an adhesive layer for attaching to a display or a substrate with high rigidity.

The adhesive layer can be provided with the near-infrared ray shielding function, color tone adjusting function and visible light transmittance adjusting function as described above. It is a preferable aspect that the adhesive layer is provided with an impact relaxation function for protecting a display from impact. For providing an adhesive layer with an impact relaxation function, the thickness of an adhesive layer is preferably 100 µm or more, and more preferably 300 µm or more. The upper limit of thickness is preferably 3000 µm or less from considering a coating qualification of adhesive layer.

For the adhesive layer, known adhesive materials or sticking materials can be used. Examples of the sticking material include acrylic, silicone, urethane, polyvinylbutyral, ethylene-vinyl acetate, and the like. Examples of the adhesive material include epoxy resins such as bisphenol A type epoxy resin, tetrahydroxyphenylmethane type epoxy resin, novolac type epoxy resin, resorcin type epoxy resin and polyolefin type epoxy resin; (di) enes such as natural rubber, polyisoprene, poly-1,2-butadiene, polyisobutene, polybutene, poly-2-heptyl-1,3-butadiene and poly-1,3-butadiene; polyethers such as polyoxyethylene, polyoxypropylene, polyvinyl ethyl ether and polyvinyl hexyl ether; polyesters such as polyvinyl acetate and polyvinyl propionate; polyurethane, ethyl cellulose, polyvinyl chloride, polyacrylnitrile, polymethacrylonitrile, polysulfone, phenoxy resin and the like.

Other preferable constitution example (B) of the laminated body of the present invention is explained. The laminated body of constitution example (B) has a conductive layer, a plastic film and a functional layer in this order. In the constitution example (B), a conductive layer and a functional layer are disposed by sandwiching a plastic film, thus, there is no restriction in the relationship between the conductive layer and functional layer (for example, thickness of conductive layer, thickness of functional layer, and relationships between both thicknesses) and, the kind of conductive mesh and the production method. However, to realize price-reduction of filter for display being a purpose of the present invention, it is preferable that no adhesive layer lies between a plastic film and a conductive layer, and between a plastic film and a functional layer.

Therefore, it is preferable to coat/form a functional layer on a plastic film, and formation of conductive mesh preferably uses the methods 1) to 5).

The filter for display of the present invention consists of the laminated body of the foregoing constitution, and has a cavity reaching at least the conductive layer, while penetrating through the functional layer from the surface of the functional layer side of laminated body, or penetrating through the functional layer and plastic film, in at least one part of the peripheral part of the laminated body. It is preferable that the cavity does not penetrate the laminated body from the viewpoints of strength of filter for display and handleability.

In the filter for display targeted by the present invention, when a filter for display is mounted in a display and fabricated into a housing, it is important to provide an electrode for electrically connecting a conductive layer to an outside electrode of the housing. Regarding the cavity, a conductive layer is exposed, and this exposed part of the conductive layer serves as an electrode.

In the present invention, a cavity is provided in at least one part of the peripheral part of a laminated body, here, the peripheral part of a laminated body means a part corresponding to the periphery of an image display region of display when a filter for display composed of such laminated body is positioned in a display, preferably, it is an inner side by 1mm or more from the edge part of a filter for display, and an outer side by 1mm or more from the part corresponding to an image display region.

The filter for display targeted by the present invention is ordinarily a rectangle, and a laminated body used for it is also rectangle. It is preferable to provide a cavity in the edge part of at least two sides facing each other, more preferably each in the edge part of four sides of the laminated body. It is preferable to form a cavity in approximately parallel to the side and linear elongated groove-shape. Additionally, "linear" herein is not only a straight line without curve, but also includes an approximate straight line having somewhat curve. The width of a cavity is preferably 3 mm or less, more preferably 2 mm or less, and further preferably 1.5 mm or less. The lower limit of the width of cavity is preferably 0.3 mm or more, and more preferably 0.4 mm or more. When the width of a cavity becomes large exceeding 3 mm, there are cases arising problems that the exposed surface of a conductive layer becomes large, the conductive layer tends to deteriorate due to oxidation, production efficiency is lowered as described below, and a conductive material tends to exfoliate when a conductive material is disposed in a cavity as described below. On the other hand, when the width of a cavity becomes 0.3 mm or less, there is a case that electric conduction to a display housing (outside electrode) becomes insufficient, and no sufficient shielding effect of electromagnetic wave is obtained.

The length of a cavity at one side of a filter for display is preferably 10% or more to that of one side, more preferably 30% or more, and particularly preferably 50% or more. Being higher in the ratio is preferable from the viewpoint of electromagnetic wave shielding performance. The cavity in the present invention may be a linear continuous cavity, or a dashed discontinuous cavity. In the latter case of discontinuous cavity, the total length corresponds to the ratio.

Hereinafter, the filter for display of the present invention will be explained in detail with reference to Drawings.

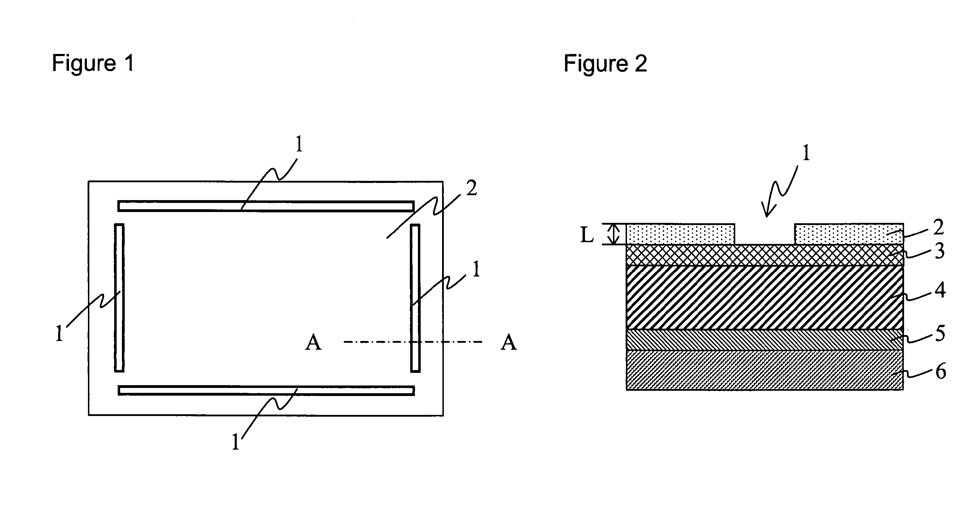

Fig. 1 is a plan view of one example (constitution example A) of filter for display according to the present invention, and Fig. 2 a pattern diagram of cross section of A-A in Fig. 1. In the peripheral part of a filter for display, a cavity 1 being approximately parallel to the side and linear elongated groove-shape is provided at four sides. In this filter for display, a conductive layer 3 is formed on a plastic film 4, and a functional layer 2 is laminated on the conductive layer 3. On the opposite surface of plastic film 4, a near-infrared ray shielding layer 5 and an adhesive layer 6 are laminated. In Fig. 2, the cavity 1 reaches the conductive layer 3 while penetrating through the functional layer 2 from the surface of the functional layer side and the conductive layer 3 is exposed. Additionally, the conductive layer 3 in Fig. 2 is composed of conductive mesh.

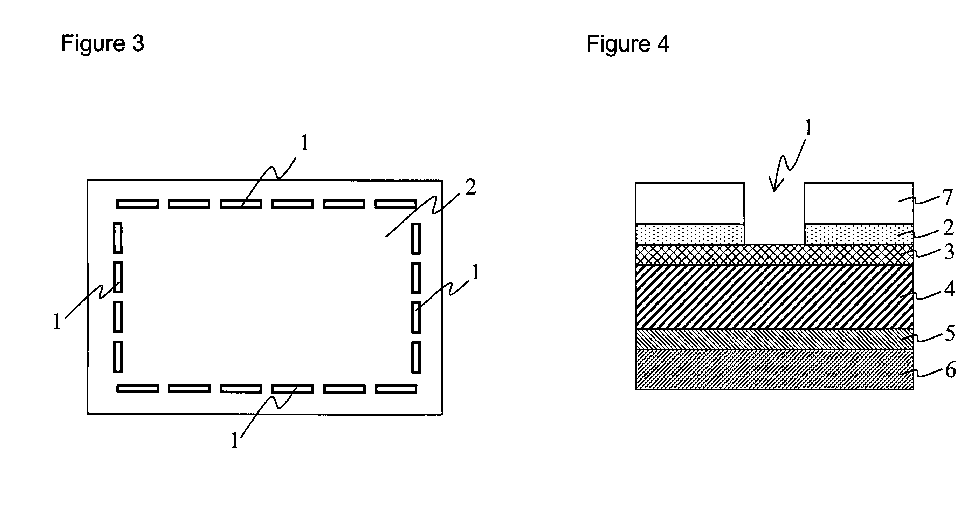

Fig.3 is a plan view of a mode that a cavity is provided in a linear, discontinuous (dashed) shape. In the peripheral part of a filter for display, a cavity 1 in approximately parallel to the side in a dashed shape is provided at four sides. In the case of providing a cavity in a dashed shape, the number of cavity parts per one side is preferably 3 to 50, and more preferably in a range of 5 to 40. A ratio (A/B) of (A) total length of cavity parts per one side to (B) total length of distance (interval) of cavity parts is preferably in a range of 0.2 to 20, and more preferably in a range of 0.5 to 10.

Next, a method of forming a cavity will be explained. In the present invention, it is preferable to form a cavity without detaching a functional layer and the like positioned on a conductive layer by a physical method, and a method of forming a cavity by evaporating or burning organic materials of a functional layer and the like is preferably used. As such method, a method of irradiating with a laser is preferably used. The method of irradiating with a laser has merits that a cavity can be formed without physical contact with a laminated body, a cavity can be formed in almost constant width, and the depth direction of cavity can be precisely controlled. Examples of a power source of such laser include iodine, YAG, and CO2, in particular, CO2 laser is preferable from the points that cavity width and cavity depth can be precisely controlled, and a cavity can be formed by evaporating/burning a functional layer without destroying a conductive layer composed of metals.

As a cavity forming method, there is a method of cutting in from the surface of a laminated body with a cuter blade such as knife, in this method, there is a case that formation of a cavity as a preferable embodiment of the present invention, namely, a cavity of 0.3 mm or more in width, is difficult and electric conduction cannot be given, and conductive mesh is easily broken and electric conduction becomes insufficient. As other method of forming a cavity, there is a method that a functional layer is removed with an ultrasonic soldering iron, but in this method, there are problems that a plastic film of a laminated body may be thermally deformed because a tip of hot iron contacts a laminated body, and it is difficult to carry out exposure of conductive layer completely and stably. Further as other method, there is a dry etching method, but this method needs a large scale apparatus, and a laminated body is sometimes deformed because of becoming high temperature during operations.

In the light of the above situations, as a method of forming a cavity in such way that conductive mesh is exposed penetrating through a functional layer and the like laminated on conductive mesh, it has found out that a method using laser is very useful.

In the case of forming a cavity by laser irradiation, the width and depth of a cavity can be controlled by adjusting the focal position of laser, power of laser, and scanning speed (head speed) of laser. The width of a cavity can be further controlled by adjusting the number of scanning, but a desired cavity of the present invention can also be formed by one scanning. The width of a cavity is preferably 3 mm or less as described above, and for forming a cavity exceeding 3 mm in width, the number of scanning of laser must be increased, so production efficiency is lowered.

A preferable production method of cavity of the present invention forms a cavity by evaporating or burning a functional layer with a laser, thus it becomes possible to expose a conductive layer completely.

In the present invention, it is possible to sufficiently ensure earth efficiency by providing the cavity. Since a filter for display of constitution (A) of the present invention has no plastic film and adhesive layer on a conductive layer, a distance from the surface of conductive layer to the outermost surface of the functional layer side of filter is very small compared with a conventional, ordinary filter for display, electric conduction to an outside electrode is sufficiently obtained even when the width of a cavity is 3 mm or less. Namely, by setting a distance (L) from the surface of conductive layer to the outermost surface to be sufficient small, it becomes possible to shorten the width of a cavity for drawing an electrode.

From these viewpoints, in a filter for display of constitution (A) of the present invention, a distance (L) from the surface of conductive layer to the outermost surface at the functional layer side of filter is preferably 30 µm or less, more preferably 20 µm or less, particularly preferably 10 µm or less. The distance (L) largely depends on the thickness of functional layer, and it can be set to in the above-described range by adjusting the total thickness of functional layers.

Also from the viewpoint of cavity formation by irradiation with a laser, setting a distance (L) from the surface of conductive layer to the outermost surface to be small is useful. Setting a distance (L) to be small means that the absolute amount of organic materials constituting a functional layer and the like becomes small, so the residual amount of decomposed materials of organic materials generated in a cavity formation by laser irradiation becomes small, thus there is a merit that contamination in the periphery of cavity part of a filter for display by the residue of decomposed materials, and contamination to peripheral apparatuses can be alleviated. Further, by setting the distance (L) to be small, the output power of laser irradiation can be made small, approaching price-reduction of laser equipment.

On the other hand, from the viewpoints of accuracy (depth accuracy of cavity) and stable operation in cavity formation by irradiation with a laser, it is preferable that depth processed by irradiation with a laser needs some extent of thickness. In a production method of the filter for display of the present invention, it is preferable that there is a step for further laminating a cover film on a functional layer in a step for obtaining a laminated body, and preferably, a step for forming a cavity is a step for forming a cavity reaching at least the conductive layer by irradiation with a laser on the surface of the cover film. This is preferable because by further laminating a cover film on the surface at the functional layer side of filter for display and conducting laser processing from above the cover film, thickness for processing by irradiation with a laser can be earned to improve accuracy of laser processing. The cover film is provided to aim at protecting a functional layer and the like, and it is lastly detached and removed. There is also a merit that forming a cavity through irradiation with a laser on above the cover film prevents the residue of decomposed materials of organic materials generated in cavity formation from reattaching onto a filter for display.

From considerations on the generation amount of the residue of decomposed materials by irradiation with a laser processing, price-reduction of laser irradiation equipment and accuracy of cavity formation, the thickness of the cover film (including an adhesive layer when an adhesive layer for lamination is required) is preferably in a range of 20 to 80 µm.

As the cover film used in the present invention, various kinds of plastic films can be used. For example, there are listed polyester films such as polyethylene terephthalate; polyolefin films such as polyethylene film, polypropylene film and polybutylene film; polyacetyl cellulose film, polyacrylic film, polycarbonate film, epoxy type film, polyurethane type film and the like, among them, polyester films and polyolefin films are preferably used.

Since the cover film is lastly detached and removed from a filter for display, a detachable sticking material or adhesive material is used. Alternatively, in the case of using a film having adhesion as a cover film, no sticking material or the like is required. It is preferable that the cover film is detached and removed before a filter for display is mounted in a display, or after mounted.

Fig. 4 is a pattern diagram of cross section of the cavity part formed in the peripheral part of laminated body with a cover film further having a cover film on the outermost surface of a laminated body. A cavity 1 reaches a conductive layer 3 from cover film 7.

A filter for display of the present invention can sufficiently have electric conduction between a conductive layer and an outside electrode only by cavity formation as described above, and it is possible to ensure electric conduction to the outside electrode stably by disposing a conductive material in a cavity part. There is also a merit that deterioration of conductive layer due to air oxidation or the like can be prevented by disposing a conductive material in a part where a conductive layer is exposed to air by a cavity.

As one mode that a conductive material is disposed in a cavity, there is a mode that a fluid conductive material such as conductive paste and solder is coated or filled in a cavity. As the conductive paste, metal pastes containing silver, gold, palladium, copper, indium, tin, or alloy of silver with metal other than itself can be used.

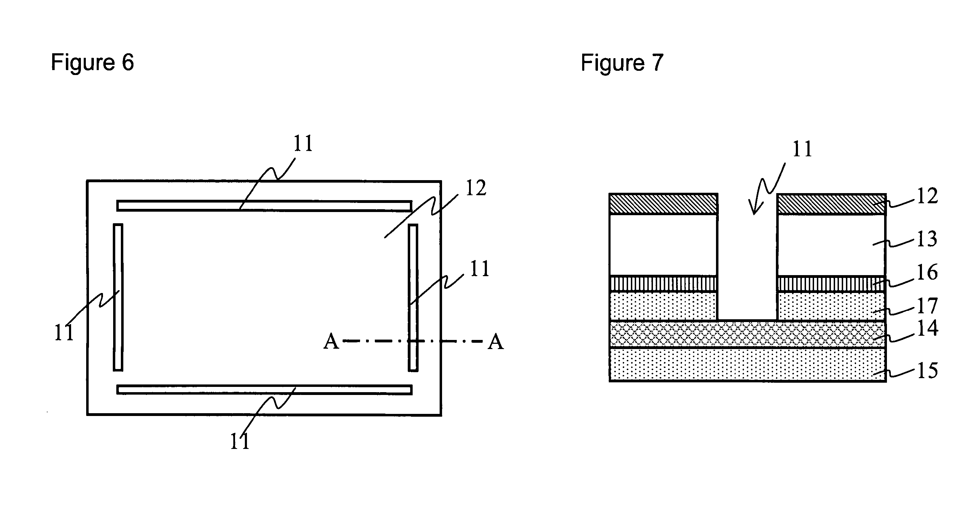

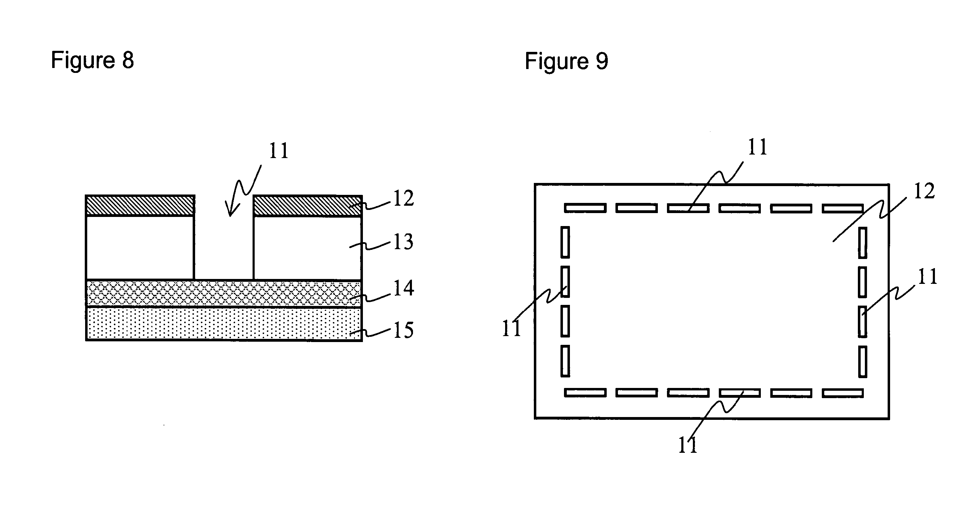

A method for forming a cavity by irradiation with a laser in a laminated body by using conductive mesh as a conductive layer can form a cavity reaching the under side layer of conductive layer (for example, plastic film 4 in Fig. 2, adhesive layer in Figs. 7 and 8 described below) through an opening part of conductive mesh without destroying conductive mesh. By coating or filling a fluid conductive material such as conductive paste into this cavity, the conductive pastes or the like enters into the under side of conductive mesh, as a result, a contact area between the conductive mesh and conductive material such conductive paste increases, and electric conduction between the conductive layer and outside electrode can be further stably ensured.

As other mode that a conductive material is disposed in a cavity, there is a mode that a conductive solid processed for it to be inserted into a cavity is disposed. As the conductive solid, a conductive metal or one that a conductive metal is clad on the surface of non-conductive material is used.

As other mode that a conductive material is disposed in a cavity, there is a mode that a conductive adhesive tape is attached from above a cavity. After a conductive adhesive tape is attached, the conductive adhesive tape is preferably heated and pressed by a heat sealer and the like. Regarding filter for display of the present invention, since a distant from the outermost surface of the filter to the surface of conductive layer is short, it is possible to contact the conductive adhesive tape with the conductive layer by heating and pressing a conductive adhesive tape. The conductive adhesive tape is one provided with an adhesive layer that conductive particles are dispersed in one surface of metal foil, as this adhesive layer, one that an acrylic type, rubber type or silicone type adhesive agent and a hardening agent are compounded in an epoxy type or phenol type resin can be used, in particular, an after-hardening type adhesive layer containing a polymer consisting of mainly ethylene-vinyl acetate type copolymer as a hardening-type conductive adhesive agent and its hardening agent is preferable.

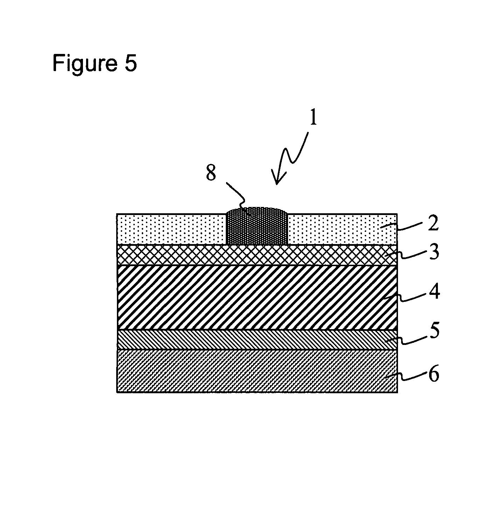

Fig.5 is a pattern diagram of cross section of filter for display that a conductive material is disposed in a cavity. A conductive material 8 comprising conductive paste or the like is coated in cavity 1, and an electrode electrically connecting to a conductive layer 3 is formed.

Cavity formation and disposition of a conductive material to a cavity (particularly, fluid conductive material such as conductive paste) are preferably carried out in a state that a cover film is present.

Next, a filter for display using a laminated body of constitution example (B) will be explained in detail with reference to Drawings. Fig. 6 is a plan view of one example of a filter for display using a laminated body of constitution example (B), and Fig. 7 is a pattern diagram of cross section of A-A in Fig. 6. In the peripheral part of a filter for display, a cavity 11 being approximately parallel to the side and linear elongated is provided at four sides. This filter for display is constituted such that a functional layer 12 on one surface of conductive layer 14, and a plastic film 13 having a near-infrared ray shielding layer 16 are laminated via adhesive layer 17, and there is an adhesive layer 15 on the other surface of conductive layer 14. In this constitution, in the case that the conductive layer 14 is metal mesh, the conductive layer 14 has a form buried by the adhesive layer 15 and/or adhesive layer 17. In Fig. 7, a cavity 11 reaches the conductive layer 14 from the functional layer 12, and the conductive layer 14 is exposed.

Fig. 8 is a pattern diagram of other example of a filter for display using a laminated body of constitution example (B) . This filter for display is constituted such that a plastic film 13 and a functional layer 12 on one surface of conductive layer 14 are contained and there is an adhesive layer 15 on the other surface of conductive layer 14. The conductive layer 14 is provided directly (not via adhesive layer) on a plastic film 13 via undercoat layer or the like (not figured). A cavity 11 reaches the conductive layer 14 while penetrating through a plastic film 13 from the functional layer 12, and the conductive layer 14 is exposed. An adhesive layer 15 has a near-infrared ray shielding function.

In Figs. 7 and 8, the cavity 11 may reach the adhesive layer 15 while penetrating through the conductive layer 14, and in the filter for display of the present invention, this mode is preferable from the point that the conductive layer contains conductive mesh. However, it is preferable that the cavity 11 does not penetrate through a filter for display.

Fig. 9 is a plan view of a mode that a cavity is provided in linear discontinuous (dashed) shape. In the peripheral part of a filter for display, a cavity 11 being approximately parallel to the side is provided in a dashed shape at four sides. The specification in the case of providing a cavity in a linear discontinuous shape is the same as the constitution example (A) .

Since a laminated body of constitution example (B) has no plastic film at the opposite side to a functional layer based on a conductive layer, there is a case that rigidity in the peripheral part that a cavity of laminated body has been provided is lowered. Therefore, this is preferable because a discontinuous cavity can suppress the lowering of rigidity in the peripheral part of a laminated body.

A method for forming a cavity of constitution example (B) preferably uses laser in the same manner as in the case of constitution example (A). Since a laminated body of constitution example (B) has a plastic film lying between a conductive layer and a functional layer, the depth of a cavity is larger compared with constitution example (A). Therefore, it is more preferable to dispose a conductive material in a cavity to ensure electric conduction between a conductive layer and an outside electrode. The conductive material is the same as in the case of constitution example (A).

Also for the constitution example (B), it is preferable that a cavity is formed from above a cover film by using a laminated body with covering film having a covering film on a functional layer, and further a fluid conductive material such as conductive paste is disposed in a cavity. The material of cover film is the same as in the case of constitution example (A). The thickness of the cover film used in the constitution example (B) is preferably 20 to 200 µm, and more preferably 30 to 100 µm.

A method for forming a cavity by irradiation with a laser forms a cavity by evaporating or burning organic materials of the part irradiated on with a laser (functional layer and plastic film), in this time, there is a case that the residue of decomposed materials of organic materials generated reattaches on the surface of a laminated body to contaminate it. It is possible to prevent the residue of organic materials evaporated from reattaching to a functional layer by forming a cavity through irradiation with a laser on above the cover film.

Further, also in the case that a fluid conductive material such as conductive paste and solder is coated or filled in a cavity by using a dispenser or the like, a cavity formed from the surface of cover film is useful. Since a cavity of the present invention is narrow in width compared with a conventional electrode as descried above, when a conductive material is coated or filled in a cavity, there is a case that a coating or filling operation position is out of alignment, so a conductive material attaches in the periphery of a cavity (the surface of functional layer), or a conductive material overfilled from a cavity attaches on a functional layer. Such problems can be solved by using a cavity formed from the surface of a cover film.

When a conductive material is coated or filled in a cavity formed from the surface of a cover film, it becomes possible to form an electrode protruded from a functional layer by filling it to the cover film side beyond the interface of the functional layer and cover film. By protruding an electrode from a functional layer, electric conduction between an electrode and the outside electrode of a housing can be ensured more stably and surely. The height protruded from the functional layer of electrode is preferably in a range of 10 to 200 µm, more preferably in a range of 15 to 150 µm, and particularly preferably in a range of 20 to 100 µm. By setting the height protruded from the functional layer to be 10 µm or more, connection to the outside electrode becomes surer. On the other hand, if the height protruded is more than 200 µm, there is a case that an electrode tends to exfoliate from a laminated body.

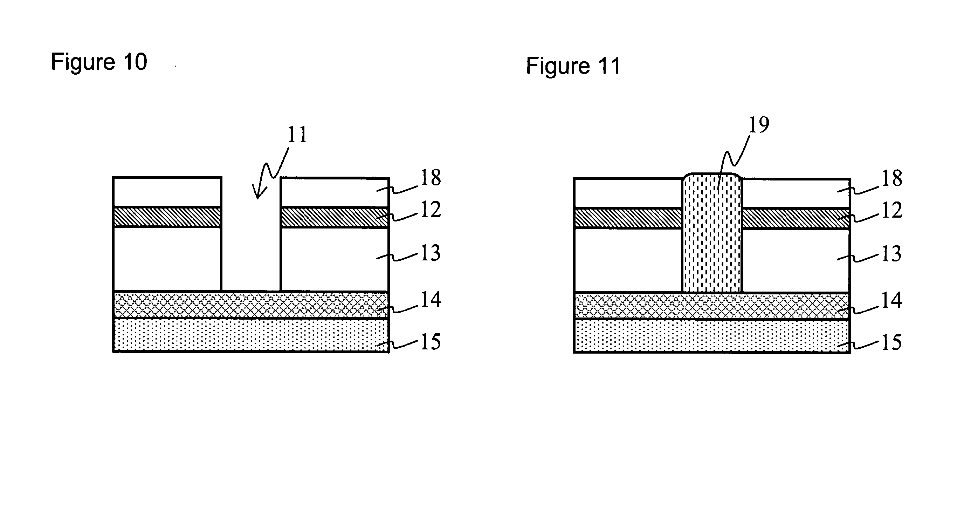

Hereinafter, a mode further having a cover film on a conductive layer of a laminated body of constitution example (B) will be explained in detail with reference to Drawings. Fig. 10 is a pattern diagram of cross section of the cavity part formed in the peripheral part of a laminated body with cover film having a cover film on a conductive layer. A cavity 11 reaches a conductive layer 14 from a cover film 18.

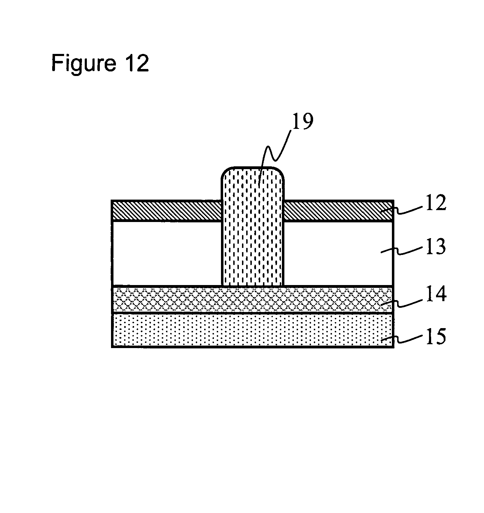

Fig. 11 is a pattern diagram of cross section when a conductive material 19 such as conductive paste is disposed in a cavity 11 in Fig. 10. The conductive paste is filled into the surface of cover film 18 of cavity 11 to form an electrode. As described above, the cover film is lastly detached and removed, and Fig. 12 shows a pattern diagram of cross section when the cover film 18 is detached and removed from a constitution of Fig. 11. The electrode composed of conductive material 19 such as conductive paste is in a shape that the part corresponding to the thickness of cover film is protruded from the surface layer.

In the case of using the laminated body with cover film, from the viewpoint of detachability of cover film from a laminated body, a discontinuous cavity is more preferable than a continuous cavity. In the case that a continuous cavity is formed in all four sides from above a cover film, depending on the length of a cavity, but the cover films at the inside and outside relative to the cavities of four sides is almost all broken leaving a part of four corners, or completely broken. In such condition, the cover film cannot be completely detached by a detachment operation once. However, in the case that a discontinuous cavity is provided from above a cover film, the total area of the connecting part of cover films at the inside and outside becomes large with respect to the cavity, so it becomes possible to detach the cover film completely by a detachment operation once.

Next, the production method of filter for display of the present invention will be explained.

A preferable production method of filter for display of the present invention has at least one of a step for obtaining a laminated body including a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function; and a step for forming a cavity reaching at least the conductive layer by irradiation with a laser on the surface of the functional layer side in at least one part of the peripheral part of said laminated body.

The production method of filter for display composed of a laminated body of constitution example (A) preferably has a step for forming a conductive layer on a plastic film, a step for obtaining a laminated body by coating a functional layer having at least one function selected from antireflection function, hard coat function and antiglare function, on the conductive layer, and a step for forming a cavity reaching at least the conductive layer by irradiation with a laser on the surface of the functional layer side in at least one part of the peripheral part of the laminated body.

Each step described above has been so far explained, it is preferable that a step for forming a conductive layer on a plastic film and a step for obtaining a laminated body by coating a functional layer on a conductive layer are continuously carried out by a roll-to-roll method.

As described above, in a preferable aspect of the present invention, a laminated body with cover film having a cover film on the surface of the functional layer side is used. Such production method preferably has a step for forming a conductive layer on a plastic film, a step for obtaining a laminated body by coating a functional layer having at least one function selected from antireflection function, hard coat function and antiglare function, on the conductive layer, a step for obtaining a laminated body with cover film by laminating a cover film on the surface of the functional layer side of said laminated body, and a step for forming a cavity reaching the conductive layer while penetrating through the cover film and functional layer from the surface of cover film by irradiation with a laser to at least one part of the peripheral part of the laminated body with cover film.

Also in the production method, it is preferable that steps are continuously carried out by a roll-to-roll method till a step for obtaining a laminated body with cover film.

In the production method of the present invention, it is preferable to have a step for laminating a near-infrared ray shielding layer on the surface opposite to the conductive layer of plastic film, and it is preferable to have a step for further laminating an adhesive layer on the near-infrared ray shielding layer. Also these steps are preferably continuously carried out by a roll-to-roll method.

The production method of the present invention preferably has further a step for disposing a conductive material in a cavity. Such step suitably coats conductive paste or solder into a cavity by a dispenser or the like.

The production method of a laminated body of constitution example (B) will be exemplified below. Such production method of a laminated body has at least a step for coating a functional layer on one surface of a plastic film and a step for forming a conductive layer on the other surface of a plastic film. In the step for coating a functional layer, it can be coated on a plastic film in the same way as that for coating a functional layer of constitution example (A). As the method for forming a conductive layer on the other surface of a plastic film, a method utilizing the method described in Japanese Unexamined Patent Publication No. 2006-66909 is listed. Namely, the method includes:
1) a step for laminating a metal foil such as copper foil on a plastic film (a) via adhesive material (b) whose adhesive force is lost by irradiation of an active energy ray such as ultraviolet;
2) a step for processing said metal foil into conductive mesh (d) by selective etching;
3) a step for laminating the surface of conductive mesh (d) and plastic film (e) having a functional layer via adhesive material (f) so that a surface not having a functional layer of plastic film (e) is faced to the surface of conductive mesh (d);
4) a step for irradiating ultraviolet from said plastic film (a) ;
5) a step for detaching the plastic film (a) and adhesive material (b); and
6) a step for laminating an adhesive material onto the surface of conductive mesh (d) exposed by said detaching step.

In the production method, it is preferable to provide a near-infrared ray shielding layer previously on the surface opposite to a functional layer of plastic film (e) having a functional layer, and further the near-infrared ray shielding layer more preferably has a tone adjusting function concomitantly.

As other method for forming a conductive layer on the other surface of a plastic film, a method utilizing Japanese Unexamined Patent Publication No. 2006-153950 is listed. Namely, the method includes:
1) a step for forming a conductive layer (h) directly on the surface opposite to a functional layer of plastic film (g) having a functional layer; and
2) a step for laminating an adhesive material (i) on the conductive layer.

In the production method, as a method for forming a conductive layer (h) directly on a plastic film (g), the methods 1) to 5) can be adopted.

In the production method, the adhesive material (i) preferably has a near-infrared ray shielding performance, and further preferably has a tone adjusting function concomitantly.

In the production method of laminated body as described above, it is preferable to carry out each step continuously by a roll-to-roll method. It is preferable that a step for laminating two or more materials (long web) via adhesive material, and a step for laminating an adhesive material on the surface of conductive mesh are carried out under a reduced pressure atmosphere. For example, the lamination step is carried out in a vacuum chamber capable of maintaining a reduced pressure state. By lamination under a reduced pressure, mixing of air bubble into layers can be effectively prevented, as a result, a transparent filter for display with a low haze value can be obtained. The degree of vacuum is, for preventing the mixing of air bubble into layers, preferably 20 kPa or less, more preferably 15 kPa or less, and particularly preferably 10 kPa or less. The lower limit is preferably about 500 Pa from the viewpoints of a time to reach a predetermined atmospheric pressure and the like. When air bubbles mix, it is necessary to increase transparency by heating and pressuring a laminated body in an autoclave or the like for a long time (generally more than 30 minutes) to miniaturize or diffuse an air bubble. By conducting a lamination step under reduced pressure atmosphere, the mixing of air bubbles is prevented and an autoclave treatment can be skipped, which greatly improves productivity.

As described above, the filter for display of the present invention can be mounted directly in a display or via known substrate with high rigidity, such as glass plate, acrylic plate and polycarbonate plate. In the latter case of mounting a filter for display in a display via known substrate with high rigidity, such as glass plate, the laminated body of the present invention is attached on a substrate with high rigidity, such as glass plate, then by adopting a method for forming an electrode of the present invention by using laser, a cavity can be formed in the laminated body. Further, a conductive material can be disposed in the cavity.

A method for forming an electrode of the present invention by using laser can be also adopted after a laminated body is mounted in a display. Namely, it is a production method of filter for display wherein a laminated body including a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function is mounted in a display so that the opposite surface of said functional layer is set to the display side, then, irradiated with a laser on the surface of the functional layer side in at least one part of the peripheral part of the laminated body to form a cavity reaching at least the conductive layer; and after a filter for display of the present invention is completed by forming a cavity by irradiation with a laser to the peripheral part of the laminated body, a display housing can be fabricated. Further, after a conductive material such as conductive paste is coated to the cavity, a display housing can be fabricated.

A preferable production method of filter for display of the present invention is a production method of filter for display that after a laminated body with cover film further having a cover film on said conductive layer is mounted in a display, a cavity reaching at least the conductive layer by irradiation with a laser on the surface of cover film in at least one part of the peripheral part of the laminated body is formed, subsequently the cover film is detached and removed. In the case of using a laminated body with cover film, after forming a cavity, or coating conductive paste in a cavity, a cover film is detached, and a filter for display of the present invention is completed, then a display housing can be fabricated.

In a method for forming an electrode of the present invention, a filter for display that an electrode is formed in a laminated body can be mounted in a display, or an electrode can be formed after the laminate body of the present invention is mounted in a display in a production process of display as described above.

In the latter case of applying to a production process of display, it is preferable that the laminate body of the present invention is supplied in a roll-shape, and in the production process of display, the roll-shape laminated body is cut to a predetermined sheet and used.

Additionally, regarding a laminated body used in a production method of display of the present invention, it is preferable to use a laminated body having a plastic film, a conductive layer and a functional layer in this order, and also preferable to use a laminated body having a conductive layer, a plastic film, and a functional layer in this order.

The laminate body of the present invention is composed of only one piece of plastic film, so rigidity is relatively low, forming a cavity after mounting the laminated body in a display is a preferable mode from consideration on handling a filter for display that a cavity is formed in a laminated body beforehand.

In the laminate body constituting the filter for display of the present invention, it becomes possible to draw an electrode by the present invention whereas an electrode cannot be drawn on four sides by the conventional technique.

### [Examples]

Hereinafter, the present invention will be explained further in detail by Examples, but the present invention is not limited to these Examples.

### Example 1

### <Formation of conductive layer having conductive mesh>

On a PET film of 100 µm in thickness (manufactured by Toray Industries, Inc. Lumilar (trademark) U34), copper deposition was conducted by a vacuum deposition method through resistance heating (degree of vacuum: 3 x 10⁻³ Pa), thereby to form a metal thin film of copper of 0.3 µm in thickness. Subsequently, by a spattering method (degree of vacuum: 0.5 Pa; target: copper, introducing gas ratio: oxygen 100%), copper oxide (metal oxide layer) of 0.05 µm in thickness was formed on the metal thin film.

The surface side of the metal thin film/metal oxide layer of the film produced was irradiated by a third harmonic of wavelength 355 nm; Nd:YAG laser, a conductive layer composed of a lattice-shaped mesh pattern with a line width of 10 µm, line pitch of 150 µm and opening ratio 87% was formed on the PET film.

### <Coating of functional layer>

On the conductive layer of PET film that the conductive layer was formed, the following hard coating layer, high refractive index layer and low refractive index layer were coated in this order.

### <Hard coating layer>

A coating material that a commercially available hard coating agent ("DeSolite Z7528" manufactured by JSR Corporation) was diluted with isopropyl alcohol for a solid content concentration to be 30% by mass was coated by a micro-gravure coater, and dried at 80°C, then hardened by irradiation of ultraviolet of 1.0 J/cm², thereby to provide a hard coating layer of 3 µm in thickness.

### <High refractive index layer>

A mixture of 6 parts by mass of tin-containing indium particle (ITO), 2 parts by mass of multifunctional acrylate, 18 parts by mass of methanol, 54 parts by mass of polypropyleneglycol monoethyl ether and 20 parts by mass of isopropyl alcohol was stirred to prepare a high refractive index coating material with 1. 67 of coat film refractive index. This coating material was coated on the hard coating layer by using a micro-gravure coater, and dried at 80°C, then the coated layer was hardened by irradiation of ultraviolet of 1.0 J/cm², thereby to form a high refractive index layer of about 0.1 µm in thickness.

### <Low refractive index layer>

A silica slurry of 144 parts by mass of hollow silica particle with an outer shell of 50 nm in primary particle diameter and 560 parts by mass of isopropyl alcohol was prepared, 219 parts by mass of methylmethoxysilane, 158 parts by mass of 3,3,3-trifluoropropylmethoxysilane, 704 parts by mass of the silica slurry and 713 parts by mass of polypropyleneglycol monoethyl ether were stirred and mixed, and the mixture was compounded with 1 part by mass of phosphoric acid and 130 parts by mass of water, hydrolyzed for 60 minutes while stirring at 30°C ± 10°C,, further the temperature was raised to 80°C ± 5°C, and polymerized for 60 minutes while stirring, thereby to obtain a silica particle-containing polymer.

Next, 1200 parts by mass of this silica particle-containing polymer and 5244 parts by mass of isopropyl alcohol were stirred and mixed, then 15 parts by mass of acetoxyaluminum as a hardening catalyst was added thereto, stirred and mixed again, thereby to prepare a coating material of 1.35 in refractive index.

This coating material was coated on the high refractive index layer by using a small diameter-gravure coater, and dried at 130°C, and hardened thereby to form a low refractive index layer of about 0.1 µm in thickness.

### <Lamination of cover film>

On the low refractive index layer, a cover film (manufactured by Nitto Denko Corporation, "E-MASK IP300"; slightly sticking layer of 5 µm laminated on PET film of 38 µm) was laminated.

### <Lamination of near-infrared ray shielding layer>

On the surface opposite to the conductive layer of the PET film, a near-infrared ray shielding layer concomitantly having an orange light shielding function (layer where a coating material that a phthalocyanine type pigment and a diimonium type pigment as near-infrared ray absorbing pigment, and tetraazaporphyrin type pigment as an orange light absorbing pigment were mixed in an acrylic type resin was coated for a dry film thickness to be 12 µm) was provided.

### <Lamination of adhesive layer>

An ultraviolet hardening type urethane acrylate resin (Hibon (trademark) manufactured by Hitachi Kasei Chemical Co., Ltd.) was coated on a separation film by using a slit die coater for the thickness to be 300 µm, and the coated film was hardened using UV irradiation equipment, sequentially a separation film was attached to obtain an adhesive layer sandwiched with separation films. Next, on the near-infrared ray shielding layer of the laminated body produced as above, the adhesive layer was laminated while detaching the separation film of one side.

The constitution of the laminated body with cover film produced as above is shown below.

### <Constitution of laminated body>

Adhesive layer/near-infrared ray shielding layer/PET film/conductive layer/functional layer (hard coating layer/high refractive index layer/low refractive index layer)/cover film

### <Formation of cavity>

The laminated body produced as above was cut to a sheet with a long side of 964 mm and a short side of 554 mm to produce a sheet-like laminated body, then this sheet-like laminated body was fixed to a laser cutter (CO2 laser cutter manufactured by Commax Co. , Ltd), the four sides of the laminated body inside by 10 mm from each edge part were irradiated linearly with a laser and a continuous linear cavity was formed thereby to obtain a filter for display of the present invention.

A cavity reaching the conductive layer from the surface of cover film was formed by setting a head speed of laser to be 1200 cm/min, and adjusting the output power of laser and focal position of laser. The number of scanning of laser was set twice per one side. The length of a cavity was 930 mm in the long side, and 520 mm in the short side. The width of a cavity measured after the cover film was detached and removed was 1. 5 mm.

### <Evaluation on earth performance of filter for display>

A simple housing (outside electrode) was produced in such manner that a gasket wrapped with a cloth woven by conductive fibers in the periphery of sponge was bonded with a conductive adhesive material on one surface of an aluminum plate of 1 mm in thickness and 2 cm in width.

Next, the filter for display produced above was disposed on an acrylic plate of 3 mm in thickness, then the cover film was detached, and the simple housing was disposed on the four edge parts of the filter for display, and fixed on the acrylic plate with a clamp. Fastening the clamp was adjusted so that a distant between the acrylic plate ad simple housing became constant.

Next, using a resistance measuring instrument "Pocket multi meter" manufactured by Multi Measuring Instruments Co., Ltd, electric conduction between the electrodes of two sides facing each other was confirmed by touching needles on the aluminum plate of the simple housing.

As a result, there was electric conduction, and grounding was confirmed.

### Example 2

A sheet-like laminated body was produced in the same manner as Example 1, and a cavity was formed in the laminated body in the same manner as Example 1. However, the number of scanning of laser was once. The width of the cavity was 0.8 mm.

Subsequently, conductive paste (silver paste "DOTITE" (trademark), manufactured by Fujikura Kasei Co., Ltd.) was coated to the cavity by a dispenser to obtain a filter for display of the present invention that an electrode was formed.

The thus produced filter for display was evaluated on earth performance in the same manner as Example 1. As a result, there was electric conduction between the electrodes of two sides facing each other, and grounding was confirmed.

### Example 3

A sheet-like laminated body was produced in the same manner as Example 1, and a cavity was formed in the same manner as Example 2 except that the cavity was a dashed shape (detail is shown below), the conductive paste was coated to the cavity in the same manner as Example 2 to obtain a filter for display of the present invention that an electrode was formed.

Dashed shape cavity: 2 cm in length of each cavity part, 1 cm in distance between cavity parts, 31 cavity parts at the long sides of laminated body, 62 cm in total length (A) of cavity parts per one side in the long side, 30 cm in total length (B) of distances between cavity parts, 17 cavity parts at the short sides of laminated body, 34 cm in total length (A) of cavity parts per one side in the short side, and 16 cm in total length (B) of distances between cavity parts.

The filter for display of the present invention produced as above was evaluated on earth performance in the same manner as Example 1, as a result, there was electric conduction between the electrodes of two sides facing each other, and grounding was confirmed.

### Example 4

A sheet-like laminated body was produced in the same manner as Example 1, and a cavity was formed in a laminated body in the same manner as Example 1. However, the number of scanning of laser was once. The width of the cavity was 0.8 mm.

Subsequently, the cover film was detached and removed, a conductive adhesive tape was attached on the cavity, and heated and pressured by a heat sealer to obtain a filter for display of the present invention that an electrode was formed.

The thus produced filter for display was evaluated on earth performance in the same manner as Example 1. As a result, there was electric conduction between the electrodes of two sides facing each other, and grounding was confirmed.

### Comparative Example 1

A sheet-like laminated body was produced in the same manner as Example 1. The cover film was detached, then by irradiation with a laser on above a functional layer, two cut lines was provided at positions of 5 mm and 10 mm from the edge part. Along the two cut lines provided at an interval of 5 cm, the functional layer was physically detached to attempt the exposure of conductive layer, but it was not possible to detach the functional layer alone. When the functional layer was forcefully detached, it was detached together with the conductive layer, and it was not possible to draw an electrode from the conductive layer.

### Example 5

On a PET film of 100 µm in thickness (manufactured by Toray Industries, Inc. Lumilar (trademark) U34), a paste containing palladium colloid was printed using a screen having a lattice-like mesh pattern of 30 µm in line width and 250 µm in line pitch, and this was immersed in a non-electrolytic plating solution to conduct non-electrolytic plating, sequentially, electrolytic plating was conducted, further electrolytic plating of Ni-Sn alloy was conducted, thereby to form a conductive layer having a conductive mesh of 5 µm in thickness. The opening ratio of the conductive mesh was 77%.

Next, on the conductive layer, a hard coating layer of Example 1 was formed by 8 µm in thickness, further, on the hard coating layer, a high refractive index layer and a low refractive index layer were coated in the same manner as Example 1. Further, in the same manner as Example 1, a cover film, a near-infrared ray shielding layer and an adhesive layer were laminated to obtain a laminated body with cover film.

Next, in the same manner as Example 1, each of cavities of 1.5 mm in width were formed on four sides, and evaluated on earth performance in the same manner as Example 1, as a result, there was electric conduction between the electrodes of two sides facing each other, and grounding was confirmed.

### Example 6

A sheet-like laminated body was produced in the same manner as Example 5, and a cavity was formed in a laminated body in the same manner as Example 5. However, the number of scanning of laser was once. The width of the cavity was 0.8 mm. Subsequently, conductive paste (silver paste "DOTITE" (trademark), manufactured by Fujikura Kasei Co., Ltd.) was coated to the cavity by a dispenser to obtain a filter for display of the present invention that an electrode was formed.

The thus produced filter for display was evaluated on earth performance in the same manner as Example 1, as a result, there was electric conduction between the electrodes of two sides facing each other, and grounding was confirmed.

### Example 7

A sheet-like laminated body was produced in the same manner as Example 5, and a cavity was formed in the same manner as Example 6 except that the cavity was a dashed shape (detail is shown below), the conductive paste was coated to the cavity in the same manner as Example 6 to obtain a filter for display of the present invention that an electrode was formed.

Dashed shape cavity: 2 cm in length of each cavity part, 1 cm in distance between cavity parts, 31 cavity parts at the long sides of laminated body, 62 cm in total length (A) of cavity parts per one side in the long side, 30 cm in total length (B) of distances between cavity parts, 17 cavity parts at the short sides of laminated body, 34 cm in total length (A) of cavity parts per one side in the short side, and 16 cm in total length (B) of distances between cavity parts.

The filter for display of the present invention produced as above was evaluated on earth performance in the same manner as Example 1, as a result, there was electric conduction between the electrodes of two sides facing each other, and grounding was confirmed.

### Example 8

A sheet-like laminated body was produced in the same manner as Example 5, and a cavity was formed in a laminated body in the same manner as Example 5. Here, the number of scanning of laser was once. The width of the cavity was 0.8 mm.

Subsequently, the cover film was detached and removed, a conductive adhesive tape was attached on the cavity, and heated and pressured by a heat sealer to obtain a filter for display of the present invention that an electrode was formed.

The thus produced filter for display was evaluated on earth performance in the same manner as Example 1. As a result, there was electric conduction between the electrodes of two sides facing each other, and grounding was confirmed.

### Example 9

The roll laminated body produced in the same manner as Example 1 was cut to a sheet of 964 mm in long side and 554 mm in short side, the thus obtained sheet-like laminated body was attached on a front plate glass of plasma display ("PP-8" manufactured by Nippon Electric Glass Co., Ltd.; thickness 1.8 mm) via the adhesive layer of the laminated body.

Subsequently, a cavity was formed from above the cover film of the laminated body in the same manner as Example 2, further conductive paste was coated to the cavity to form an electrode.

Next, the cover film was removed from the laminated body, the simple housing used in Example 1 was disposed in the edge parts of four sides of the laminated body, and fixed on the front plate with a clamp. Fastening the clamp was adjusted so that a distant between the front plate and simple housing became constant.

Next, using a resistance measuring instrument "Pocket multi meter" manufactured by Multi Measuring Instruments Co., Ltd, electric conduction between the electrodes of two sides facing each other was confirmed by touching needles on the aluminum plate of the simple housing. As a result, there was electric conduction, and grounding was confirmed.

### Example 10

A conductive layer composed of conductive mesh of 5 µm in thickness was formed on a PET film in the same manner as Example 5.

Further, on the conductive layer, a coating material for hard coating layer with the following composition was coated by a micro-gravure coater, dried at 80°C, then by irradiation of ultraviolet of 1.0 J/cm², the coated layer was hardened to form a hard coating layer of 10 µm in thickness.

### <Composition of hard coating layer>

Urethane acrylate A (UN-3220HA manufactured by Negami Chemical Industrial Co., Ltd.); 2.75 parts,
Urethane acrylate B (U4HA manufactured by Shin-Nakamura Chemical Co., Ltd.); 2.75 parts,
Photopolymerization initiator (Irgacure 184 manufactured by Ciba Geigy Company., Ltd.); 0.3 parts,
Isopropyl alcohol; 1.25 parts, and Methyl ethyl ketone; 1.25 parts

Next, on the surface opposite to the conductive layer of the PET film, a near-infrared ray shielding layer and an adhesive layer were laminated in the same manner as Example 1 to obtain a laminated body.

### <Constitution of laminated body>

Adhesive layer/near-infrared ray shielding layer/PET film/conductive layer/functional layer (hard coating layer)

Next, the laminated body was cut to a sheet in the same manner as Example 1 to give a sheet-like laminated body, this sheet-like laminated body was irradiated with a laser in the same manner as Example 1 (herein, the number of operation was once), cavities (line width is 0.8 mm) reaching the conductive layer from the surface of the functional layer were formed on four sides.

The earth performance was evaluated in the same manner as Example 1, as a result, there was electric conduction between the electrodes of two sides facing each other, and grounding was confirmed.

### Comparative Example 2

A sheet-like laminated body was produced in the same manner as Example 10. A linear cut was provided in four sides of this sheet-like laminated body inside by 10 mm from each edge part with a cutter knife. The length of the cut is 930 mm in long side and 520 mm in short side.

Next, conductive paste was coated on the cut in the same manner as Example 2.

The earth performance was evaluated in the same manner as Example 1. As a result, there was no electric conduction between the electrodes of two sides facing each other, and it was not possible to have grounding.

### Example 11

A conductive layer composed of conductive mesh of 5 µm in thickness was formed on a PET film in the same manner as Example 5. Further, the following coating material for antiglare hard coating layer was coated on the conductive layer by a micro-gravure coater, dried at 80°C, then by irradiation of ultraviolet of 1.0 J/cm², the coated layer was hardened to form an antiglare hard coating layer of 8 µm in thickness.

### <Coating material for antiglare hard coating layer>

A commercially available hard coating agent (Opstar (trademark) Z7534 manufactured by JSR Corporation) was diluted with methyl ethyl ketone for a solid content concentration to be 50% by mass, further, acrylic type fine particles of 1.5 µm in average particle diameter (Chemisnow (trademark) MX series manufactured by Soken Chemical & Engineering Co., Ltd.) was added thereto by 1% by mass relative to the solid content of the hard coating agent.

### <Production of laminated body>

Next, on the surface opposite to the conductive layer of the PET film, a near-infrared ray shielding layer and an adhesive layer were laminated in the same manner as Example 1 thereby to obtain a laminated body.

### <Constitution of laminated body>

Adhesive layer/near-infrared ray shielding layer/PET film/conductive layer/functional layer (antiglare hard coating layer)

Next, the laminated body was cut to a sheet in the same manner as Example 1 to give a sheet-like laminated body, this sheet-like laminated body was irradiated with a laser in the same manner as Example 1 (herein, the number of operation was once), and cavities (width is 0.8 mm) reaching the conductive layer from the surface of the functional layer were formed on four sides. The earth performance was evaluated in the same manner as Example 1, as a result, there was electric conduction between the electrodes of two sides facing each other, and grounding was confirmed.

### Example 12

On a PET film of 100 µm in thickness, a photosensitive layer containing the following photosensitive silver salt (silver halide emulsion layer) was coated, and subjected to exposure, development and plating treatment, and a conductive layer composed of conductive mesh was formed.

### <Photosensitive layer>

An emulsion containing a silver iodide particle (AgI = 2 mole %) of 0.05 µm in circle-equivalent average particle diameter including 7.5 g of gelatin based on 60 g of silver in an aqueous medium was prepared. To this emulsion, K3Rh2Br9 and K2IrC16 were added for each concentration to be 10⁻⁷ (mol/mol silver), so Rh ion and Ir ion were doped in silver iodide particle. Na2PdC14 was added to this emulsion, further after gold/sulfur sensitizing was carried out using chlorauric acid and sodium thiosulfate, a gelatin film hardening agent and a surfactant were added thereto, thereby preparing a coating liquid for photosensitive layer.

The coating liquid for photosensitive layer was coated on one surface of the PET film for the coated amount of silver to be 1 g/m².

### <Exposure, Development>

A photosensitive layer provided on a PET film was exposed via photomask of mesh pattern by using an ultraviolet lamp, and subjected to development treatment by using the following developer and fixer, then rinsed with pure water.

### [Developer]

Hydroquinone 0.037 mol/L
N-methylaminophenol 0.016 mol/L
Sodium metaborate 0.140 mol/L
Sodium hydroxide 0.360 mol/L
Sodium iodide 0.031 mol/L
Potassium metabisulfite 0.187 mol/L

### [Fixer]

### "Super Fuji Fix" manufactured by Fuji Film Corporation

### <Plating treatment>

The mesh composed of developed silver prepared as above was subjected to a non-electrolytic plating treatment at 45°C with plating solution (non-electrolytic Cu plating solution of pH=12.5, containing 0.06 mol/L of copper sulfate, 0.22 mol/L of formalin, 0.12 mol/L of triethanolamine, 100 ppm of polyethylene glycol, 50 ppm of potassium ferrocyanide and 20 ppm of α,α'-bipyridine), then subjected to oxidation treatment with aqueous solution containing 100 ppm of Fe(III) ion to obtain conductive mesh. The conductive mesh formed as above was 5 µm in thickness, 10 µm in line width, 200 µm in line pitch, and 90% in opening ratio.

### <Coating of hard coating layer>

A hard coating layer was coated/formed on the conductive layer produced above in the same manner as Example 10.

### <Production of laminated body>

On the surface opposite to the conductive layer of the PET film, a near-infrared ray shielding layer and an adhesive layer were laminated in the same manner as Example 1 to obtain a laminated body.

Next, in the same manner as Example 1, the laminated body was cut to a sheet to give a sheet-like laminated body, this laminated body was irradiated with a laser (herein, the number of operation is once) in the same manner as Example 1, and cavities (width is 0.8 mm) reaching the conductive layer from the surface of the functional layer were formed on four sides.

The earth performance was evaluated in the same manner as Example 1, as a result, there was electric conduction between the electrodes of two sides facing each other, and grounding was confirmed.

### Example 13

An antireflection film with cover film was prepared in such manner that on an antireflection layer of antireflection film (antireflection film "Lumiclear" (trademark) manufactured by Toray Industries, Inc.) having an antireflection layer (functional layer) on a PET film of 100 µm in thickness, a cover film (manufactured by Nitto Denko Corporation, "E-MASK IP300J; slightly sticking layer of 5 µm laminated on PET film of 38 µm) was further laminated.

On the surface opposite to the surface that the antireflection layer of this antireflection film was provided, a near-infrared ray shielding layer concomitantly having an orange light shielding function (layer where a coating material that a phthalocyanine type pigment and a diimonium type pigment as a near-infrared ray absorbing pigment and tetraazaporphyrin type pigment as an orange light absorbing pigment were mixed in an acrylate type resin was coated for a dry film thickness to be 12 µm) was provided.

On the near-infrared ray shielding layer, further, an acrylic type sticking material (base material "BPS5896" manufactured by Toyo Ink MFG Co., Ltd. and hardening agent "BXX4773" were compounded by 100 : 0.5) was coated for the film thickness to be 20 µm.

On the other hand, on a PET film of 25 µm, a sticking material shown below was coated for the thickness to be 10 µm.

### <Composition of adhesive layer>

A mixture of 9.4 parts by weight of 2-methacryloyloxyethylisocyanate, 13.6 parts by weight of 1-(4-(2-hydroxyethoxy)phenyl)-2-hydroxy-2-methyl-1-propane-1-one (photopolymerization initiator, "Irgacure 2959" manufactured by Ciba Speciality Chemicals Co., Ltd.), 0.02 parts by weight of dibutyltin dilaurate, 0.02 parts by weight of hydroquinone and 76.96 parts by weight of methyl ethyl ketone was reacted under a mixed gas stream of nitrogen and oxygen at 80°C for 5 hours, thereby to obtain an intermediate solution for synthesizing photopolymerization initiator-graft polymer with nonvolatile content of 22.5%.

A mixture of 70 parts by weight of the intermediate solution, 113 parts by weight of butyl acrylate, 5 parts by weight of acrylic acid, 0.12 parts by weight of azobisisobutyronitrile and 212 parts by weight of ethyl acetate was heat-refluxed under nitrogen atmosphere, and reacted for 7 hours to obtain a photopolymerization initiator-graft polymer solution with weight average molecular weight of 440000 and nonvolatile content of 33%.

In 100 parts by weight of the photopolymerization initiator-graft polymer solution obtained, 2.0 parts by weight of glycerol polyglycidyl ether as a hardening agent ("Denacol EX-421" manufactured by Nagase Chemtex Corporation)), 0.05 parts by weight of dimethylbenzylamine as a hardening catalyst (tertiary amine) and 25 parts by weight of hexafunctional urethane acrylate oligomer ("Ebecryl 1290K" manufactured by Daicel UCB were compounded thereby to obtain an adhesive material.

Next, a copper foil of 10 µm in thickness was laminated on the surface of this adhesive material. Subsequently, this copper foil was formed/processed to a lattice-like copper mesh (line width: 15 µm; line pitch: 250 µm; opening ratio: 88%) via photolithography step (attachment of resist film-exposure-development-chemical etching-detachment of resist film) to form a conductive layer composed of copper mesh through an adhesive material on a PET film. Further, the surface of the copper mesh obtained and the surface of both sides were subjected to blacking treatment (oxidation treatment).

Next, the film having the copper mesh produced above (copper mesh film) and the antireflection film were laminated so that the copper mesh surface and the adhesive surface of antireflection film were faced. Subsequently, after irradiation by a metal halide lamp from the PET film side of the copper mesh film of laminated body, the PET film of the copper mesh film side and the adhesive layer were detached from the laminated body, and the copper mesh surface was exposed.

Next, one separation film of an acrylic type sticking material sheet (base material "BPS5896" manufactured by Toyo Ink MFG Co., Ltd. and hardening agent "BXX4773" were compounded by 100 : 0.5, and separation films were disposed on the both sides of sticking material) was detached, and laminated on the copper mesh surface of the laminated body. The thickness of the sticking material is 20 µm.

The layer constitution of the thus produced laminated body with cover film is shown below.

### <Layer constitution of laminated body>

Sticking material/copper mesh (conductive layer)/sticking material/near-infrared ray shielding layer/PET film/antireflection layer/cover film

The laminated body was cut to a sheet with a long side of 964 mm and a short side of 554 mm to produce a sheet-like laminated body, then this sheet-like laminated body was fixed to a laser cutter (manufactured by Commax Co., Ltd.; CO2 laser head, maximum output power 200 W), the four sides of the laminated body inside by 10 mm from each edge part were irradiated linearly with a laser and a continuous linear cavity was formed thereby to obtain a member for display of the present invention.

A cavity reaching the copper mesh from the surface of cover film was formed by setting a head speed of laser to be 1200 cm/min, and adjusting the output power and focal position of laser. The number of scanning of laser was set once per one side.

The length of a cavity was 930 mm in the long side and 520 mm was in the short side, and the width of a cavity was 0.8 mm.

Subsequently, conductive paste (silver paste "DOTITE" (trademark), manufactured by Fujikura Kasei Co., Ltd.) was coated to the cavity by a dispenser to obtain a filter for display of the present invention that an electrode was formed. The electrode formed with the conductive paste had a shape protruded by about 40 µm from the functional layer (antireflection layer) .

### <Evaluation on earth performance of filter for display>

It was evaluated in the same manner as Example 1. As a result, there was electric conduction between the electrodes of two sides facing each other, and grounding was confirmed.

### Example 14

A sheet-like laminated body was produced in the same manner as Example 13, and a cavity was formed in the same manner as Example 13 except that the cavity was a dashed shape (detail is shown below), the conductive paste was coated to the cavity in the same manner as Example 13 to obtain a filter for display of the present invention that an electrode was formed.

Dashed shape cavity: 2 cm in length of each cavity part, 1 cm in distance between cavity parts, 31 cavity parts at the long sides of laminated body, 62 cm in total length (A) of cavity parts per one side in the long side, 30 cm in total length (B) of distances between cavity parts, 17 cavity parts at the short sides of laminated body, 34 cm in total length (A) of cavity parts per one side in the short side, and 16 cm in total length (B) of distances between cavity parts.

The filter for display of the present invention produced as above was evaluated on earth performance in the same manner as Example 1, as a result, there was electric conduction between the electrodes of two sides facing each other, and grounding was confirmed.

### Comparative Example 3

A sheet-like laminated body was produced in the same manner as Example 13.

The cover film was detached, then by irradiation with a laser on above a functional layer (antireflection layer), two cut lines were provided at positions of 5 mm and 10 mm from the edge part. Along the two cut lines provided at an interval of 5 cm, the antireflection film was physically detached to attempt the exposure of copper mesh, but when the antireflection film was detached, the copper mesh was broken or the sticking material remained on the copper mesh, so it was not possible to draw an electrode from the conductive layer.

### Example 15

An antireflection film with cover film was prepared in such manner that on an antireflection layer of antireflection film (antireflection film "Lumiclear" (trademark) manufactured by Toray Industries, Inc.) having an antireflection layer (functional layer) on a PET film of 100 µm in thickness, further, a cover film (manufactured by Nitto Denko Corporation, "E-MASK IP300J; slightly sticking layer of 5 µm laminated on PET film of 38 µm) was laminated.

Next, on the surface opposite to the surface that the antireflection layer of the antireflection film was provided, paste containing palladium colloid was printed using a screen having a lattice-like mesh pattern of 30 µm in line width and 250 µm in line pitch, 77% in opening ratio, and this was immersed in a non-electrolytic plating solution to conduct non-electrolytic plating, sequentially, electrolytic plating was conducted, further electrolytic plating of Ni-Sn alloy was conducted, thereby to form a mesh-like conductive layer.

Next, on the surface of the conductive layer, an acrylic resin type adhesive agent containing a diimonium type pigment and a phthalocyanine type pigment as a near-infrared ray absorbing pigment was formed in thickness of 25 µm.

### <Constitution of laminated body>

Adhesive material (containing a near-infrared ray absorbing pigment)/conductive layer/PET film/antireflection layer/cover film

The laminated body was cut to a sheet with a long side of 964 mm and a short side of 554 mm to produce a sheet-like laminated body, then this sheet-like laminated body was fixed to a laser cutter (manufactured by Commax Co., Ltd.; CO2 laser head, maximum output power 200 W), the four sides of the laminated body inside by 10 mm from each edge part were irradiated linearly with a laser and a continuous linear cavity was formed thereby to obtain a filter for display of the present invention.

A cavity reaching the conductive layer from the surface of cover film was obtained by setting a head speed of laser to be 1200 cm/min, and adjusting the output power and focal position of laser.

The number of scanning of laser was set once per one side. The length of a cavity was 930 mm in the long side and 520 mm was in the short side, and the width of a cavity was 0.8 mm.

Subsequently, conductive paste (silver paste "DOTITE" (trademark), manufactured by Fujikura Kasei Co., Ltd.) was coated to the cavity by a dispenser to obtain a filter for display of the present invention that an electrode was formed. The electrode formed with the conductive paste had a shape protruded by about 40 µm from the functional layer (antireflection layer) .

The thus produced filter for display of the present invention was evaluated on earth performance in the same manner as Example 1, as a result, there was electric conduction between the electrodes of two sides facing each other, and grounding was confirmed.

### Example 16

A sheet-like laminated body was produced in the same manner as Example 15, and a cavity was formed in the same manner as Example 15 except that the cavity was a dashed shape (detail is shown below), the conductive paste was coated to the cavity in the same manner as Example 15 to obtain a filter for display of the present invention that an electrode was formed.

Dashed shape cavity: 2 cm in length of each cavity part, 1 cm in distance between cavity parts, 31 cavity parts at the long sides of laminated body, 62 cm in total length (A) of cavity parts per one side in the long side, 30 cm in total length (B) of distances between cavity parts, 17 cavity parts at the short sides of laminated body, 34 cm in total length (A) of cavity parts per one side in the short side, and 16 cm in total length (B) of distances between cavity parts.

The filter for display of the present invention produced as above was evaluated on earth performance in the same manner as Example 1, as a result, there was electric conduction between the electrodes of two sides facing each other, and grounding was confirmed.

### Comparative Example 4

A sheet-like laminated body was produced in the same manner as Example 15.

The cover film was detached, then by irradiation with a laser on above a functional layer (antireflection layer), two cut lines were provided at positions of 5 mm and 10 mm from the edge part. Along the two cut lines provided at an interval of 5 cm, the antireflection film was physically detached to attempt the exposure of conductive layer, but it was not possible to detach the antireflection film alone in a condition leaving conductive layer. Namely, it was not possible to draw an electrode connecting to the conductive layer from the antireflection layer side.

### Example 17

The roll laminated body produced in the same manner as Example 15 was cut to a sheet of 964 mm in long side and 554 mm in short side, the thus obtained sheet-like laminated body was attached on a front plate glass of plasma display ("PP-8" manufactured by Nippon Electric Glass Co., Ltd.; thickness 1.8 mm) via the adhesive layer (containing a near-infrared ray absorbing pigment) of the laminated body.

Subsequently, a cavity was formed from above the cover film of the laminated body in the same manner as Example 5, and further conductive paste was coated to the cavity to form an electrode.

Next, the cover film was removed from the laminated body, the simple housing used in Example 1 was disposed in the edge parts of four sides of the laminated body, and fixed on the front plate with a clamp. Fastening the clamp was adjusted so that a distant between the front plate and simple housing became constant.

Next, using a resistance measuring instrument "Pocket multi meter" manufactured by Multi Measuring Instruments Co., Ltd, electric conduction between the electrodes of two sides facing each other was confirmed by touching needles on the aluminum plate of the simple housing. As a result, there was electric conduction, and grounding was confirmed.

### Example 18

On one side of a PET film of 100 µm in thickness (manufactured by Toray Industries, Inc. Lumilar (trademark) U34), an antiglare hard coating layer was coated/formed for the thickness to be 3 µm in the same manner as Example 11.

On the other surface of the PET film, a conductive layer was formed in the same manner as Example 15, further on the surface of the conductive layer, an acrylic resin type adhesive agent containing a diimonium type pigment and a phthalocyanine type pigment as a near-infrared ray absorbing pigment was formed in thickness of 25 µm.

### <Constitution of laminated body>

Adhesive material (containing near-infrared ray absorbing pigment)/conductive layer/PET film/antiglare hard coating layer/cover film

Next, a sheet-like laminated body was prepared in the same manner as Example 15, a cavity was formed and conductive paste was coated in the same manner. Herein, the coating amount of conductive paste was adjusted so that a height of an electrode protruded from the antiglare hard coating layer was 20 µm.

The thus produced filter for display was evaluated on earth performance in the same manner as Example 1, as a result, there was electric conduction between the electrodes of two sides facing each other, and grounding was confirmed.

### INDUSTRIAL APPLICABILITY

The present invention aims at providing a filter for display capable of realizing price-reduction and obtaining electric conduction to a display housing (outside electrode) easily and sufficiently by using a laminated body comprising only one piece of plastic film as a substrate (laminated body also containing a conductive layer and a functional layer in addition thereto), and its production method.

## Claims

1. A filter for display, which is a laminated body comprising:
a conductive layer having a conductive mesh,
one plastic film disposed only in one side of said conductive layer, and
a functional layer disposed at the viewing side relative to said conductive layer and plastic film and having at least one function selected from antireflection function, hard coat function and antiglare function,
which has a cavity reaching at least the conductive layer, while penetrating through the functional layer from the surface of the functional layer side, in at least one part of the peripheral part of said laminated body.

2. The filter for display according to claim 1, wherein no adhesive layer lies between said conductive layer and plastic film, between said conductive layer and functional layer, or between said plastic film and functional layer.

3. The filter for display according to claim 1, wherein said laminated body has a plastic film, a conductive layer and a functional layer in this order.

4. The filter for display according to claim 1, wherein said laminated body has a conductive layer, a plastic film, and a functional layer in this order.

5. The filter for display according to claim 1, wherein said cavity is of a broken line shape or a continuous straight line shape, and a groove-like cavity of 0.3 to 3 mm in width.

6. The filter for display according to claim 3, wherein said functional layer is formed by coating on the conductive layer.

7. The filter for display according to claim 1, wherein a thickness of said conductive layer is in a range of 0.2 to 6 µm.

8. The filter for display according to claim 1, wherein a total thickness of said functional layer is in a range of 1 to 20 µm.

9. The filter for display according to claim 1, wherein a conductive material is disposed in said cavity.

10. The filter for display according to claim 1, wherein a conductive adhesive tape is attached covering said cavity.

11. The filter for display according to claim 1, further having at least one function selected from near-infrared ray shielding function, color tone adjusting function and visible light transmittance adjusting function.

12. A production method of filter for display, comprising at least:
a step for obtaining a laminated body comprising a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function; and
a step for forming a cavity reaching at least the conductive layer by irradiation with a laser on the surface of the functional layer side in at least one part of the peripheral part of said laminated body.

13. The production method of filter for display according to claim 12, wherein the step for obtaining said laminated body comprises at least a step for forming a conductive layer on a plastic film and a step for coating a functional layer on the conductive layer.

14. The production method of filter for display according to claim 12, wherein the step for obtaining said laminated body comprises at least a step for coating a functional layer on one surface of a plastic film and a step for forming a conductive layer on the other surface of a plastic film.

15. The production method of filter for display according to claim 12, wherein the step for obtaining said laminated body has further a step for laminating a cover film on the functional layer, and the step for forming said cavity is a step for forming a cavity reaching at least the conductive layer by irradiation with a laser on the surface of the cover film.

16. The production method of filter for display according to claim 12, having further a step for disposing a conductive material into the cavity following the step for forming said cavity.

17. A production method of display wherein
a laminated body comprising a conductive layer having a conductive mesh, one plastic film disposed only in one side of said conductive layer, and a functional layer disposed at the viewing side relative to said conductive layer and plastic film and having at least one function selected from antireflection function, hard coat function and antiglare function is mounted in a display so that the opposite surface of said functional layer is set to be the display side, then, irradiated with a laser on the surface of the functional layer side in at least one part of the peripheral part of the laminated body to form a cavity reaching at least the conductive layer.

18. The production method of display according to claim 17, wherein said laminated body has a plastic film, a conductive layer and a functional layer in this order.

19. The production method of display according to claim 17, wherein said laminated body has a conductive layer, a plastic film, and a functional layer in this order.

20. The production method of display according to claim 17, wherein a laminated body with a cover film having a cover film further on said functional layer is mounted in a display, then,
at least one part of the peripheral part of the laminated body is irradiated with a laser on the surface of the cover film to form a cavity reaching at least the conductive layer, and then, the cover film is detached and removed.

21. The production method of display according to claim 17, wherein after forming said cavity, further a conductive material is disposed in the cavity.
